# EUROPEAN PATENT APPLICATION

(11) **EP 2 562 591 A1**
(43) Date of publication of application: **27.02.2013**
(21) Application number: 11771718.1
(22) Date of filing: 06.04.2011
(51) Int. Cl.: G02F 1/1339

(54) **DISPLAY DEVICE AND MANUFACTURING METHOD THEREFOR**

(30) Priority: 19.04.2010 JP 2010095879
(71) Applicant: Sharp Kabushiki Kaisha, Osaka-shi, Osaka 545-8522 (JP)
(72) Inventor: MORIWAKI, Hiroyuki, Osaka-shi, Osaka 545-8522 (JP)
(74) Representative: Müller - Hoffmann & Partner
(86) International application number: PCT/JP2011/002045
(87) International publication number: WO 2011/132374

(57) **Abstract**

In a display device in which a frame-like sealing member (40) containing in-sealing-member materials including at least either of pulverized glass fiber materials (42) and conductive beads (43) is provided between a first substrate (30) and a second substrate (20) in an outer perimeter portion thereof, and a display region is formed inside the sealing member (40), a protruding rib (36) is provided on the first substrate (30) in a midway portion in a width direction of the sealing member (40), extending along the sealing member (40) and protruding toward the second substrate (20) with a gap being provided between the protruding rib (36) and the second substrate (20). A distribution density of the in-sealing-member materials in the sealing member (40) in a region (SL2) corresponding to the protruding rib (36) is lower than that in a region (SL1) located further from the center of the substrate than the protruding rib (36), or the in-sealing-member materials are not contained in the sealing member (40) in the region (SL2) corresponding to the protruding rib (36).

## Description

### TECHNICAL FIELD

The present invention relates to display devices, such as a liquid crystal display device, etc., which include two opposite substrates which are bonded together by a frame-like sealing member provided in an outer perimeter portion of a display region. The present invention also relates to methods for manufacturing the display devices.

### BACKGROUND ART

Liquid crystal display devices can have a smaller thickness and lower power consumption, and therefore, are widely used as displays for mobile information apparatuses, such as a television set, an OA apparatus (e.g., a personal computer, etc.), a mobile telephone, a personal digital assistant (PDA), etc.

A liquid crystal display device includes a liquid crystal display panel and a backlight unit attached to the back surface of the liquid crystal display panel. The liquid crystal display panel includes an array substrate including switching elements (e.g., thin film transistors, etc.) and a counter substrate facing the array substrate, which are bonded together by a sealing member. A liquid crystal material is enclosed in a space between the two substrates. The counter substrate is slightly smaller than the array substrate, and therefore, a portion of the array substrate is exposed. On such an exposed region (terminal region), a drive circuit is mounted.

The liquid crystal display panel has a display region in which an image is displayed and a frame-like non-display region which surrounds the display region.

An alignment film is formed in a surface contacting the liquid crystal layer of the array substrate, covering at least the display region. Similarly, an alignment film is formed in a surface contacting the liquid crystal layer of the counter substrate, covering at least the display region. The alignment film has a function of controlling the alignment of liquid crystal molecules in the liquid crystal layer in the absence of a potential difference between an electrode provided in the array substrate and an electrode provided in the counter substrate. The alignment film also has a function of controlling the alignment and tilt of liquid crystal molecules in the presence of a potential difference between the two electrodes.

The alignment film may be formed by performing a rubbing treatment on a surface of a resin film of polyimide, etc. The resin film is formed by flexographic printing, inkjet printing, etc. Of these techniques, inkjet printing is preferably employed for the following reasons: the resin film can be drawn or applied directly to the substrate; contamination can be reduced due to the non-contact process; the amount of solution consumed can be reduced; the time required can be reduced; etc.

Incidentally, when inkjet printing is used to form the resin film (alignment film), a material having a lower viscosity than that used in flexographic printing is used as a material for the resin film, and therefore, the alignment film material is likely to leak and spread out around a region (display region) in which the alignment film should be printed. If the non-display region around the display region is so small that a large space cannot be ensured between the display region and the sealing member region, the resin film may flow to reach a region of the sealing member. In this case, the adhesiveness between the sealing member and the alignment film is insufficient, and therefore, the gap between the two substrates cannot be completely sealed, so that the liquid crystal material of the liquid crystal layer may leak.

In order to solve the above problem, PATENT DOCUMENT 1 describes a liquid crystal display device including a groove portion which is provided in a generally annular region which is located outside the display region and inside the region in which the sealing member is provided, and extends along an outer perimeter of the display region. With this configuration, even if the liquid resin material applied by inkjet printing spreads out of the display region, the groove portion can reduce or prevent the resin material from further spreading, whereby the spread outside the display region of the alignment film can be reduced or prevented.

PATENT DOCUMENT 2 describes a liquid crystal display device in which ridges and grooves are provided in a region which is located outside the display region and inside the region in which the sealing member is provided. With this configuration, even in a liquid crystal display device having a narrow picture-frame, the spread of the alignment film can be reduced or prevented, whereby the failure of sealing can be reduced or prevented.

### CITATION LIST

### PATENT DOCUMENTS

PATENT DOCUMENT 1: Japanese Patent Publication No. 2007-322627
PATENT DOCUMENT 2: Japanese Patent Publication No. 2008-145461

### SUMMARY OF THE INVENTION

### TECHNICAL PROBLEM

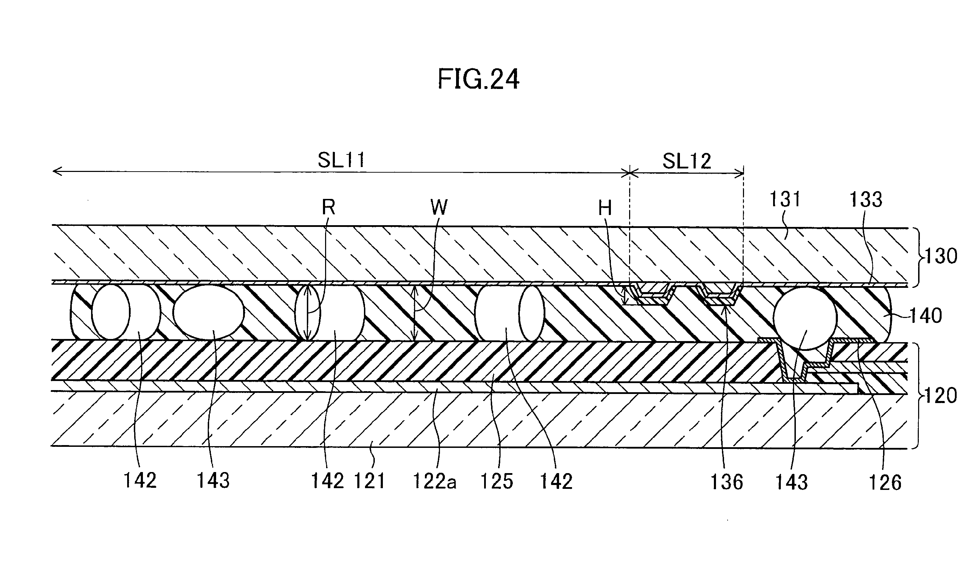

In recent years, liquid crystal display devices have had a narrower picture-frame in order to improve the design. Therefore, for example, as shown in FIG. 24, even if ridge portions (protruding ribs) 136 are provided outside the display region in order to reduce or prevent the alignment film from spreading to the seal region, a sufficient margin between the ridge portion 136 and the seal region cannot be ensured, and therefore, a sealing member140 cannot be prevented from entering a region in which the ridge portions 136 are provided.

Incidentally, the sealing member 140 contains pulverized glass fiber materials 142 which serve as a spacer for providing a predetermined distance between the two substrates. The fiber diameter R of the pulverized glass fiber material 142 is set to correspond to the substrate-to-substrate distance W in a region SL11 in which the ridge portion 136 is not provided. However, in the liquid crystal display device described in PATENT DOCUMENT 2, in which the ridge portion 136 is provided, if the pulverized glass fiber material 142 is stuck on top of the ridge portion 136 in a region SL12 corresponding to the ridge portion 136, the distance between the two substrates 120 and 130 excluding the ridge portion 136 becomes equal to the sum of the fiber diameter R of the pulverized glass fiber material 142 and the height H of the ridge portion 136, so that it becomes difficult to control the substrate-to-substrate distance W into an intended value. Therefore, it is desirable to reduce or prevent the pulverized glass fiber material 142 contained in the sealing member 140 from entering the region SL12 in which the ridge portion 136 is provided.

The sealing member 140 also contains, for example, conductive beads 143 which serve as a transfer member for establishing conduction between components above and below the sealing member 140, i.e., a common electrode 133 covering the entire surface of the counter substrate 130 and interconnects provided in the non-display region of the array substrate 120. However, if the conductive bead 143 flows over the ridge portion 136 and enters the display region (the conductive bead 143 on the right side in FIG. 24), it is likely that conduction is established, for example, between the electrode 126 of the array substrate 120 and the common electrode 133 of the counter substrate 130, so that an unintended leakage current occurs and therefore display characteristics are lowered. Therefore, the flow of the conductive bead 143 into the display region needs to be reduced or prevented.

It is an object of the present invention to provide a display device in which a frame-like sealing member containing in-sealing-member materials including at least either of pulverized glass fiber materials and conductive beads is provided between a first substrate and a second substrate in an outer perimeter portion, and a rib protruding toward the second substrate is provided in a midway portion of the first substrate in a width direction of the sealing member, extending along the sealing member, with a gap being provided between the second substrate and the protruding rib, and in which the following situations are reduced or avoided: the pulverized glass fiber material is stuck on top of the protruding rib and therefore it becomes difficult to control the cell thickness of the display device; and the conductive bead enters the display region, so that an unintended leakage current occurs between the substrates.

### SOLUTION TO THE PROBLEM

A display device according to the present invention is one in which a frame-like sealing member containing in-sealing-member materials including at least either of pulverized glass fiber materials and conductive beads is provided between a first substrate and a second substrate in an outer perimeter portion thereof, and a display region is formed inside the sealing member. A protruding rib is provided on the first substrate in a midway portion in a width direction of the sealing member, extending along the sealing member and protruding toward the second substrate with a gap being provided between the protruding rib and the second substrate. A distribution density of the in-sealing-member materials in the sealing member in a region corresponding to the protruding rib is lower than that in a region located further from the center of the substrate than the protruding rib, or the in-sealing-member materials are not contained in the sealing member in the region corresponding to the protruding rib.

In the display device of the present invention, the in-sealing-member materials preferably include the pulverized glass fiber materials and the conductive beads. A distribution density of the pulverized glass fiber materials in the sealing member in the region corresponding to the protruding rib is preferably lower than that in the region located further from the center of the substrate than the protruding rib, or the pulverized glass fiber materials are not contained in the sealing member in the region corresponding to the protruding rib. Distribution densities of the conductive beads in the sealing member in the region corresponding to the protruding rib and a region located closer to the display region than the protruding rib, are preferably lower than that in the region located further from the center of the substrate than the protruding rib, or the conductive beads are preferably not contained in the sealing member in the region corresponding to the protruding rib or the region located closer to the display region than the protruding rib.

With the above configuration, the distribution density of the in-sealing-member materials in the sealing member in the region corresponding to the protruding rib is lower than that in the region located further from the center of the substrate than the protruding rib, or the in-sealing-member materials are not contained in the sealing member in the region corresponding to the protruding rib. Of the in-sealing-member materials, the distribution density of the pulverized glass fiber materials in the sealing member in the region corresponding to the protruding rib is lower than that in the region located further from the center of the substrate than the protruding rib, or the pulverized glass fiber materials are not contained in the sealing member in the region corresponding to the protruding rib. Therefore, the number of the pulverized glass fiber materials stuck on top of the protruding rib can be reduced, or no pulverized glass fiber material is stuck on the protruding rib, and therefore, it is possible to reduce or avoid a situation that the cell thickness cannot be controlled.

With the above configuration, the distribution densities of the conductive beads in the sealing member in the region corresponding to the protruding rib and the region located closer to the display region than the protruding rib, are lower than that in the region located further from the center of the substrate than the protruding rib, or the conductive beads are not contained in the sealing member in the region corresponding to the protruding rib or the region located closer to the display region than the protruding rib. Therefore, it is possible to reduce or prevent occurrence of an unintended leakage current between the two substrates.

In the display device of the present invention, the distribution density of the pulverized glass fiber materials in the sealing member in the region corresponding to the protruding rib is preferably 1/4 or less of that in the region located further from the center of the substrate than the protruding rib. Note that the lower the distribution density of the pulverized glass fiber materials in the sealing member in the region corresponding to the protruding rib, the more it is preferable.

In the display device of the present invention, a diameter of the conductive beads is preferably larger than a fiber diameter of the pulverized glass fiber materials.

In the display device of the present invention, the first substrate may have a rectangular shape, and the protruding rib may extend along two opposite sides of the first substrate included in the substrate outer perimeter portion.

With the above configuration, even when the non-display region is narrowed (narrower picture-frame) at the two opposite sides at which the protruding rib extends, it is possible to reduce or prevent a situation that the cell thickness cannot be controlled due to the pulverized glass fiber material stuck on the protruding rib and a situation that an unintended leakage current occurs between the two substrates due to the conductive bead which is contained in the sealing member in the region corresponding to the protruding rib and the region located closer to the display region than the protruding rib. For example, in an active matrix substrate in which a source terminal region is formed along one side of the substrate terminal region and a gate terminal region is provided along two opposite sides between which the source terminal region is interposed, the source terminal region requires a wider space than that which is required by the gate terminal region because redundant interconnects for repairing source interconnects need to be provided in the source terminal region, and therefore, it is desirable that the picture-frame be narrowed only along the two sides extending along the gate terminal region. In this case, the above configuration is preferably employed.

In the display device of the present invention, the protruding rib may be formed in the substrate outer perimeter portion in the shape of a frame surrounding the display region.

With the above configuration, even when the non-display region is narrowed (narrower picture-frame) along the entire substrate outer perimeter portion, it is possible to reduce or prevent a situation that the cell thickness cannot be controlled due to the pulverized glass fiber material stuck on the protruding rib and a situation that an unintended leakage current occurs between the two substrates due to the conductive bead which is contained in the sealing member in the region corresponding to the protruding rib and the region located closer to the display region than the protruding rib.

In the display device of the present invention, a liquid crystal layer may be provided between the first and second substrates. In this case, the display device is a liquid crystal display device.

When the display device is a liquid crystal display device, the first substrate may be a counter substrate including a color filter layer, and the protruding rib may have a multilayer structure including a color filter layer, a transparent conductive film, and a transparent resin.

In this case, in the liquid crystal display device, the first substrate may further include, in the display region, a liquid crystal alignment limiting rib of a transparent resin protruding toward the second substrate.

With the above configuration, even when the display device is a liquid crystal display device, the protruding rib is provided on the counter substrate including a color filter layer. Therefore, if the protruding rib has a multilayer structure including a color filter layer, a transparent conductive film, and a transparent resin, the color filter layer of the protruding rib can be formed simultaneously with the color filter layer of the counter substrate, whereby the step of manufacturing the protruding rib can be simplified.

When the liquid crystal alignment limiting rib is provided in the display region of the first substrate, protruding toward the second substrate, the transparent resin of the protruding rib and the transparent resin of the liquid crystal alignment limiting rib can be simultaneously formed, whereby the step of manufacturing the protruding rib can be simplified.

A method for manufacturing a display device according to the present invention is a method for manufacturing a display device in which a frame-like sealing member containing in-sealing-member materials including at least either of pulverized glass fiber materials and conductive beads is provided between a first substrate and a second substrate in an outer perimeter portion thereof, and a display region is formed inside the sealing member. The method includes: providing a protruding rib along the outer perimeter portion of the first substrate; after the providing, applying a sealing member material including a flowable adhesive and the in-sealing-member materials to the first substrate in a region located further from the center of the substrate than the protruding rib, the region being a sealing member material applied region; after the applying, stacking the first and second substrates together while sandwiching the sealing member material and pressing the first and second substrates against each other, thereby spreading the adhesive to flow to a region located further inside than the protruding rib and limiting flow of the in-sealing-member materials into the region located further inside than the protruding rib by the protruding rib; and after the stacking, curing the adhesive to form a frame-like sealing member in which a distribution density of the in-sealing-member materials in the sealing member in a region corresponding to the protruding rib is lower than that in the region located further from the center of the substrate than the protruding rib, or the in-sealing-member materials are not contained in the sealing member in the region corresponding to the protruding rib, thereby obtaining the display device having the display region inside the sealing member.

In the display device manufacturing method of the present invention, the in-sealing-member materials preferably include the pulverized glass fiber materials and the conductive beads. After the sealing member material is applied to the sealing member material applied region, the first and second substrates are preferably pressed against each other while sandwiching the sealing member material, thereby spreading the adhesive to flow to the region located further inside than the protruding rib and limiting flow of the pulverized glass fiber materials and the conductive beads into the region located further inside than the protruding rib by the protruding rib. After the pressing, the adhesive is preferably cured to form the sealing member in which a distribution density of the pulverized glass fiber materials in the sealing member in the region corresponding to the protruding rib is lower than that in the region located further from the center of the substrate than the protruding rib, or the pulverized glass fiber materials are not contained in the sealing member in the region corresponding to the protruding rib, and distribution densities of the conductive beads in the sealing member in the region corresponding to the protruding rib and a region located closer to the display region than the protruding rib, are lower than that in the region located further from the center of the substrate than the protruding rib, or the conductive beads are not contained in the sealing member in the region corresponding to the protruding rib or the region located closer to the display region than the protruding rib.

With the above method, the sealing member material including the flowable adhesive and the in-sealing-member materials is applied to the first substrate in the region (sealing member material applied region) located further from the center of the substrate than the protruding rib. Therefore, even when the first and second substrates are stacked together and pressed against each other while sandwiching the sealing member material to cause the adhesive to flow into a region located further inside than the protruding rib, flow of the in-sealing-member materials into the region located further inside than the protruding rib can be limited by the protruding rib. Therefore, when the pulverized glass fiber materials are contained as the in-sealing-member materials in the sealing member, the sealing member which is obtained by subsequently curing the adhesive can be configured so that the distribution density of the pulverized glass fiber materials in the sealing member in the region corresponding to the protruding rib is lower than that in the region located further from the center of the substrate than the protruding rib, or the pulverized glass fiber materials are not contained in the sealing member in the region corresponding to the protruding rib. Therefore, the number of the pulverized glass fiber materials stuck on top of the protruding rib can be reduced, and therefore, it is possible to reduce or avoid a situation that the cell thickness cannot be controlled due to the pulverized glass fiber material stuck on the protruding rib.

When the conductive beads are contained as the in-sealing-member materials in the sealing member, the sealing member which is obtained by subsequently curing the adhesive can be configured so that the distribution densities of the conductive beads in the sealing member in the region corresponding to the protruding rib and the region located closer to the display region than the protruding rib are lower than that in the region located further from the center of the substrate than the protruding rib, or the conductive beads are not contained in the sealing member in the region corresponding to the protruding rib or the region located closer to the display region than the protruding rib. Therefore, it is possible to reduce or prevent occurrence of an unintended leakage current between the two substrates.

In the display device manufacturing method of the present invention, a diameter of the conductive beads is preferably larger than a fiber diameter of the pulverized glass fiber materials.

In the display device manufacturing method of the present invention, a distance between the sealing member material applied region and a region in which the protruding rib is provided is preferably 100-300 µm.

With the above method, the distance between the sealing member material applied region and the region in which the protruding rib is provided is 100 µm or more. Therefore, after the sealing member material is applied, the two substrates are put close to each other and stacked on top of each other and pressed against each other while sandwiching the sealing member material, whereby the adhesive is spread. However, because the distance between the sealing member material applied region and the region in which the protruding rib is provided is 100 µm or more, when the adhesive pressed and spread toward the display region has reached the region in which the protruding rib is provided, the distance between the tip of the protruding rib and the surface of the second substrate can be made smaller than the fiber diameter of the pulverized glass fiber material. Therefore, even if the adhesive is pressed and spread to a region located closer to the display region than the protruding rib, flow of the pulverized glass fiber material is blocked by the protruding rib because the distance between the tip of the protruding rib and the substrate surface on which a protruding rib is not provided is smaller than the fiber diameter of the pulverized glass fiber material. Therefore, it is possible to reduce or prevent a situation that the pulverized glass fiber material is stuck on top of the protruding rib or that the pulverized glass fiber material flows over the protruding rib toward the display region. When the sealing member material adhesive further contains the conductive bead, even if the adhesive is pressed and spread to a region located closer to the display region than the protruding rib, flow of the conductive bead is blocked by the protruding rib because the distance between the tip of the protruding rib and the substrate surface on which a protruding rib is not provided is smaller than the diameter of the conductive bead. Therefore, it is possible to reduce or prevent a situation that the conductive bead is stuck on top of the protruding rib or that the conductive bead flows over the protruding rib toward the display region. Moreover, because the distance between the sealing member material applied region and the region in which the protruding rib is provided is 300 µm or less, the outer perimeter portion of the display region can be reduced or prevented from increasing unnecessarily.

In the display device manufacturing method of the present invention, the first substrate may have a rectangular shape, and the protruding rib may extend along two opposite sides of the first substrate included in the substrate outer perimeter portion.

With the above method, even when the non-display region is narrowed (narrower picture-frame) at the two opposite sides at which the protruding rib extends, it is possible to reduce or prevent a situation that the cell thickness cannot be controlled due to the pulverized glass fiber material stuck on the protruding rib and a situation that an unintended leakage current occurs between the two substrates due to the conductive bead which is contained in the sealing member in the region corresponding to the protruding rib and the region located closer to the display region than the protruding rib.

In the display device manufacturing method of the present invention, the protruding rib may be formed in the substrate outer perimeter portion in the shape of a frame surrounding the display region.

With the above method, even when the non-display region is narrowed (narrower picture-frame) along the entire substrate outer perimeter portion, it is possible to reduce or prevent a situation that the cell thickness cannot be controlled due to the pulverized glass fiber material stuck on the protruding rib and a situation that an unintended leakage current occurs between the two substrates due to the conductive bead which is contained in the sealing member in the region corresponding to the protruding rib and the region located closer to the display region than the protruding rib.

In the display device manufacturing method of the present invention, after the sealing member is formed, a liquid crystal material may be introduced into a region surrounded by the sealing member to form a liquid crystal layer. Alternatively, after the sealing member material is applied and before the first and second substrates are bonded together, a liquid crystal material may be introduced into a region surrounded by the sealing member, and after the first and second substrates are bonded together, the liquid crystal layer may be formed. In this case, the fabricated display device is a liquid crystal display device.

When the display device manufacturing method of the present invention is a method for manufacturing a liquid crystal display device, the first substrate may be a counter substrate including a color filter layer, the protruding rib may have a multilayer structure including a color filter layer, a transparent conductive film, and a transparent resin, and the color filter layer of the protruding rib may be formed simultaneously with the color filter layer provided in the counter substrate.

In this case, in the liquid crystal display device, the first substrate may further include, in the display region, a liquid crystal alignment limiting rib of a transparent resin protruding toward the second substrate, and the transparent resin of the protruding rib and the liquid crystal alignment limiting rib may be simultaneously formed.

With the above configuration, the display device is a liquid crystal display device, and the protruding rib is formed on a counter substrate including a color filter layer. Therefore, if the protruding rib has a multilayer structure of a color filter layer, a transparent conductive film, and a transparent resin, the color filter layer of the protruding rib can be formed simultaneously with the color filter layer of the counter substrate, whereby the step of manufacturing the protruding rib can be simplified.

Moreover, if a liquid crystal alignment limiting rib protruding toward the second substrate is provided in the display region of the first substrate, the transparent resin of the protruding rib and the transparent resin of the liquid crystal alignment limiting rib can be simultaneously formed, whereby the step of manufacturing the protruding rib can be simplified.

### ADVANTAGES OF THE INVENTION

According to the present invention, a display device can be obtained in which a sealing member is formed so that the distribution density of in-sealing-member materials in the sealing member in a region corresponding to a protruding rib is lower than that in a region located further from the center of the substrate than the protruding rib, or the in-sealing-member materials are not contained in the sealing member in the region corresponding to the protruding rib. Therefore, when the in-sealing-member materials include pulverized glass fiber materials, it is possible to reduce or prevent a situation that the cell thickness cannot be controlled due to the pulverized glass fiber material stuck on the protruding rib. When the in-sealing-member materials include conductive beads, it is possible to reduce or prevent occurrence of an unintended leakage current between the two substrates. As a result, excellent optical characteristics can be obtained, and therefore, excellent display quality can be obtained.

### BRIEF DESCRIPTION OF THE DRAWINGS

[FIG. 1] FIG. 1 is a plan view of a liquid crystal display device according to a first embodiment.
[FIG. 2] FIG. 2 is a cross-sectional view taken along line II-II of FIG. 1.
[FIG. 3] FIG. 3 is a plan view of an array substrate.
[FIG. 4] FIG. 4 is an enlarged plan view of an interconnect switching portion in a region IV of FIG. 3.
[FIG. 5] FIG. 5 is a cross-sectional view taken along line V-V of FIG. 4.
[FIG. 6] FIG. 6 is an enlarged plan view of a variation of the interconnect switching portion.
[FIG. 7] FIG. 7 is a cross-sectional view taken along line VII-VII of FIG. 6.
[FIG. 8] FIG. 8 is a plan view of a counter substrate.
[FIG. 9] FIG. 9 is a cross-sectional view taken along line IX-IX of FIG. 8.
[FIG. 10] FIG. 10 is an enlarged plan view of a region X in the vicinity of the non-display region of FIG. 1.
[FIG. 11] FIG. 11 is a cross-sectional view taken along line XI-XI of FIG. 10.
[FIG. 12] FIG. 12 is a cross-sectional view of a liquid crystal display device according to a variation of the first embodiment in the vicinity of the non-display region.
[FIG. 13] FIG. 13 is a flowchart of a method for manufacturing the liquid crystal display device of the first embodiment.
[FIG. 14] FIG. 14 is a plan view of the method for manufacturing the liquid crystal display device of the first embodiment in a state in which a sealing member material is applied to the counter substrate.
[FIG. 15] FIG. 15 is a cross-sectional view taken along line XV-XV of FIG. 14.
[FIG. 16] FIG. 16 is a cross-sectional view of the method for manufacturing the liquid crystal display device of the first embodiment in a state in which the counter substrate and the array substrate are stacked together.
[FIG. 17] FIG. 17 is a cross-sectional view of the method for manufacturing the liquid crystal display device of the first embodiment in a state in which the counter substrate and the array substrate are being bonded together.
[FIG. 18] FIG. 18 is a plan view of the method for manufacturing the liquid crystal display device of the first embodiment in a state in which the counter substrate and the array substrate are being bonded together.
[FIG. 19] FIG. 19 is a plan view of the method for manufacturing the liquid crystal display device of the first embodiment in a state in which the counter substrate and the array substrate have been bonded together.
[FIG. 20] FIG. 20 is a plan view of a liquid crystal display device according to a second embodiment.
[FIG. 21] FIG. 21 is a plan view of an array substrate according to the second embodiment.
[FIG. 22] FIG. 22 is a plan view of a counter substrate according to the second embodiment.
[FIG. 23] FIG. 23 is a plan view of a counter substrate according to a variation of the second embodiment.
[FIG. 24] FIG. 24 is an enlarged cross-sectional view of a conventional liquid crystal display device in the vicinity of the non-display region.

### DESCRIPTION OF EMBODIMENTS

Embodiments of the present invention will be described in detail hereinafter with reference to the accompanying drawings. In first and second embodiments described below, an active matrix drive type liquid crystal display device including a thin film transistor (TFT) for each pixel will be described as an example display device. Note that the present invention is not intended to be limited to these embodiments and may have other configurations.

### «First Embodiment»

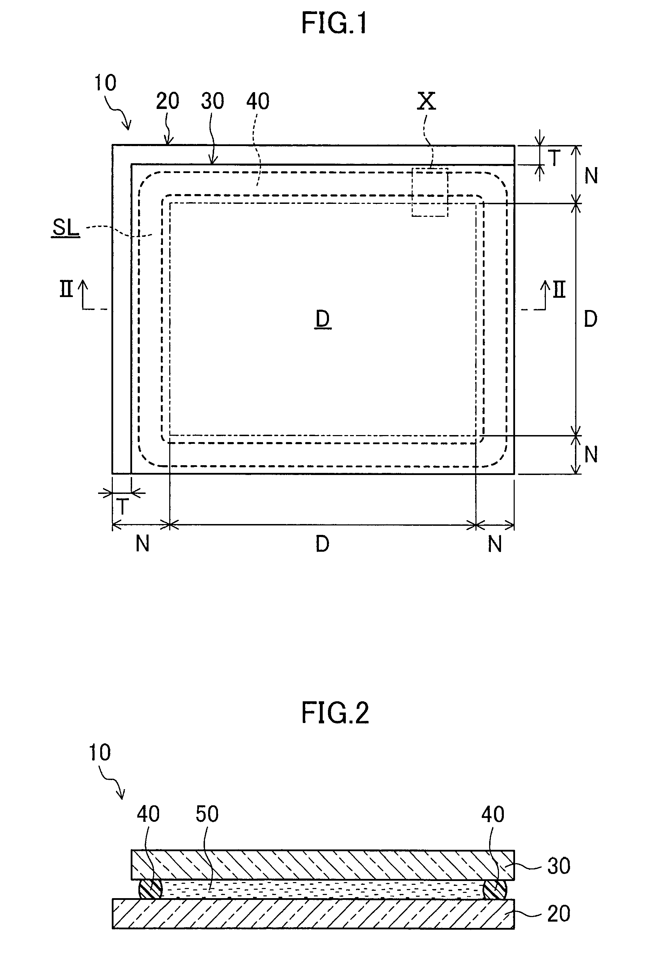

FIGS. 1 and 2 show a liquid crystal display device 10 according to the first embodiment. The liquid crystal display device 10 includes an array substrate (second substrate) 20 and a counter substrate (first substrate) 30, which face each other. The two substrates 20 and 30 are bonded together by a frame-like sealing member 40 provided in an outer perimeter portion (seal region SL) thereof. A liquid crystal layer (display layer) 50 is provided in a space between the two substrates 20 and 30 that is surrounded by the sealing member 40.

The liquid crystal display device 10 has a display region D in which a plurality of pixels are formed inside the sealing member 40 and arranged in a matrix, and a non-display region N which is provided around the display region D. A portion of the non-display region N serves as a terminal region T in which external connection terminals (parts mounted, etc.) are attached. Specifically, as shown in FIG. 1, the array substrate 20 protrudes from the counter substrate 30 at at least one end portion of the liquid crystal display device 10, and the protruding portion is the terminal region T.

### (Array Substrate)

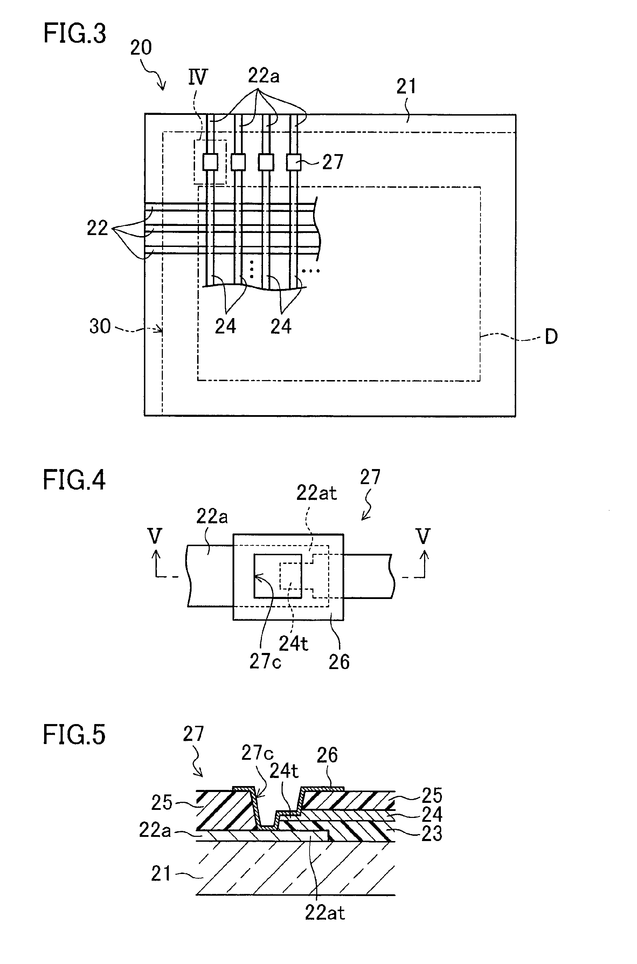

As shown in FIG. 3, in the array substrate 20, a plurality of gate lines (first interconnects) 22 having a multilayer structure including, for example, a Ti film (thickness: about 50 nm), an Al film (thickness: about 300 nm), and a Ti film (thickness: about 50 nm) are provided on a substrate body 21, extending in parallel to each other, and a gate insulating film 23 (see FIG. 5), for example, of SiN having a thickness of 400 nm is provided to cover the gate lines 22. A plurality of source lines (second interconnects) 24 having a multilayer structure including, for example, an Al film (thickness: about 300 nm) and a Ti film (thickness: about 50 nm) are provided on the gate insulating film 23, extending in parallel to each other in a direction perpendicular to the gate lines 22.

In the display region D, a semiconductor layer is provided at intersection portions of the gate lines 22 and the source lines 24 to form TFTs (not shown). A passivation film (not shown), for example, of SiN having a thickness of 250 nm is provided to cover the TFTs. An interlayer insulating film 25, for example, of photosensitive acrylic resin having a thickness of 2.5 µm is provided to cover the passivation film. A contact hole (not shown) extending from a surface of the interlayer insulating film 25 to a TFT is provided for each pixel. A pixel electrode (not shown), for example, of ITO is provided for each contact hole. An alignment film (not shown) is provided on the pixel electrodes, covering the display region D.

As shown in FIGS. 4 and 5, in the non-display region N, the source line 24 is electrically connected to a lead line 22a provided in the same layer in which the gate line 22 is provided. A source line end portion 24t is positioned above a lead line end portion 22at, overlapping the lead line end portion 22at as viewed from above, a contact hole 27c extending to both the source line 24 and the lead line 22a is formed, and an interconnect switching electrode 26 is provided to cover a surface of the contact hole 27c, and these components constitute an interconnection switching portion 27. Note that the interconnect switching electrode 26 is provided in the same layer in which the pixel electrode is provided, in the display region D.

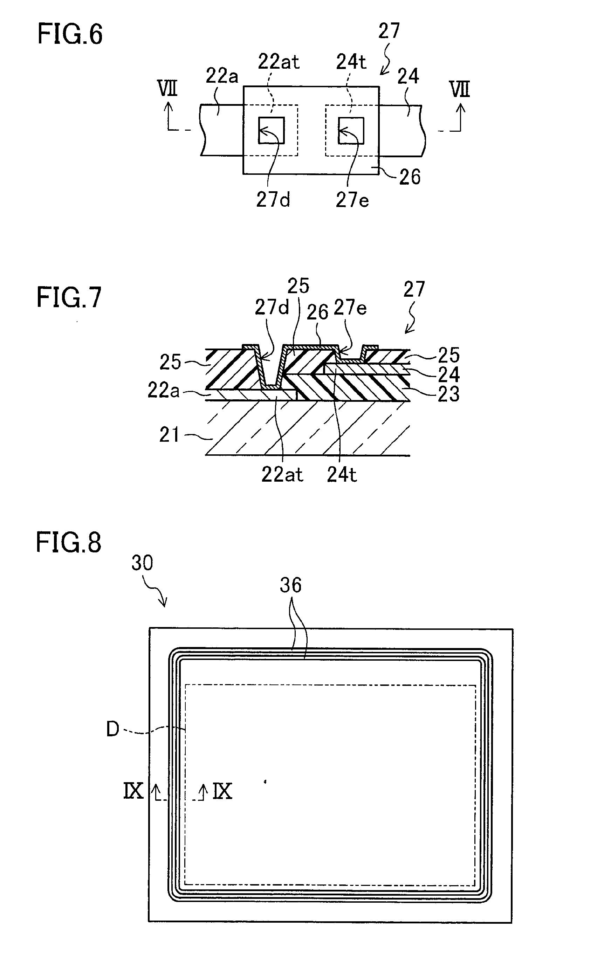

Note that, in addition to the above configuration, for example, as shown in FIGS. 6 and 7, the interconnection switching portion 27 may be configured so that the lead line end portion 22at and the source line end portion 24t are positioned so that they do not overlap as viewed from above, and a contact hole 27d which reaches from the substrate surface to the lead line end portion 22at, and a contact hole 27e which reaches from the substrate surface to the source line end portion 24t, are separately formed.

### (Counter Substrate)

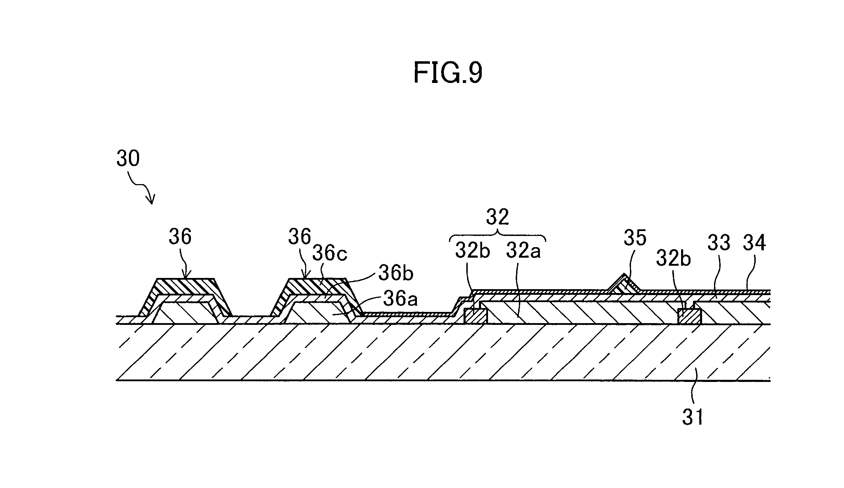

FIG. 8 is a plan view of the counter substrate 30. FIG. 9 is a cross-sectional view of a region including the non-display region N of the counter substrate 30. In the counter substrate 30, a color filter layer 32 having a thickness of, for example, 2 µm is provided on a substrate body 31 in the display region D. The color filter layer 32 includes color layers 32a having one of red, green, and blue colors corresponding to the respective pixel electrodes of the array substrate 20, and a black matrix 32b provided between each color layer 32a. A common electrode 33, for example, of ITO having a thickness of 100 nm is provided on the color filter layer 32 over the entire substrate surface. An alignment film 34 of transparent organic resin (e.g., polyimide, etc.) is provided to cover the common electrode 33.

When the liquid crystal display device 10 is of vertical alignment type, the counter substrate 30 includes, in the display region D, liquid crystal alignment limiting ribs 35 for limiting the alignment direction of liquid crystal molecules. The liquid crystal alignment limiting rib 35 protrudes from a surface of the counter substrate 30 toward the array substrate 20. The liquid crystal alignment limiting rib 35 has, for example, a triangular cross-sectional shape. In the driven state, the liquid crystal alignment limiting rib 35 substantially limits the alignment direction of each liquid crystal molecule to the protruding direction of the rib to reduce or avoid a situation that falling liquid crystal molecules interact with each other to cause the twist angle of the liquid crystal molecule to vary in a plane of the liquid crystal layer 50. As a result, high-quality display having a high contrast ratio can be provided. The liquid crystal alignment limiting rib 35 is formed, for example, of a transparent organic resin material or a transparent inorganic material, etc. The liquid crystal alignment limiting rib 35 may have insulating properties or dielectric properties.

In the counter substrate 30, a protruding rib 36 which extends along a direction of the seal region SL and protrudes toward the array substrate 20 is provided in a midway portion in a width direction of the seal region SL in which the sealing member 40 is formed. The protruding rib 36 is formed in the shape of a frame to surround the display region D. For example, a plurality of the protruding ribs 36 are arranged side by side in the width direction (two lines in FIGS. 8 and 9). The protruding rib 36 is formed, for example, of a multilayer structure of a color filter 36a, a transparent conductive film 36b, and a transparent resin 36c. The color filter 36a has a thickness of, for example, 1-3 µm. The transparent conductive film 36b is formed, for example, of an ITO film having a thickness of about 100 nm, and serves as a common electrode covering the entire surface of the counter substrate 30. The transparent resin 36c is, for example, photosensitive acrylic resin having a thickness of 1.5 µm. The protruding rib 36 has a function of reducing or preventing the alignment film 34 from flowing out over the protruding rib 36 during formation of the alignment film 34. The protruding rib 36 also has a function of reducing or preventing pulverized glass fiber materials 42 or conductive beads 43 contained in the sealing member 40 from being stuck on top of the protruding rib 36 and flowing into a region SL3 located further inside than the protruding rib 36.

Each protruding rib 36 has a width of about 50 µm and a height of 3-6 µm and has a generally-trapezoidal cross-section taken along the width direction, for example. Note that the protruding rib 36 is designed so that a gap is formed between the protruding rib 36 and the array substrate 20, i.e., the height of the protruding rib 36 is smaller than the distance between the array substrate 20 and the counter substrate 30. The adjacent protruding ribs 36 arranged side by side in the width direction are spaced apart from each other by a distance of, for example, about 25 µm. The protruding rib 36 is preferably provided at a position which is located further inside (closer to the display region D) in a midway portion in the width direction of the seal region SL. For example, the protruding rib 36 is formed in a region which is located about 100 µm away from an inner end of the seal region SL in the width direction of the seal region SL.

Although the foregoing example illustrates the counter substrate 30 which includes the liquid crystal alignment limiting rib 35, the liquid crystal alignment limiting rib 35 may be removed.

### (Sealing Member)

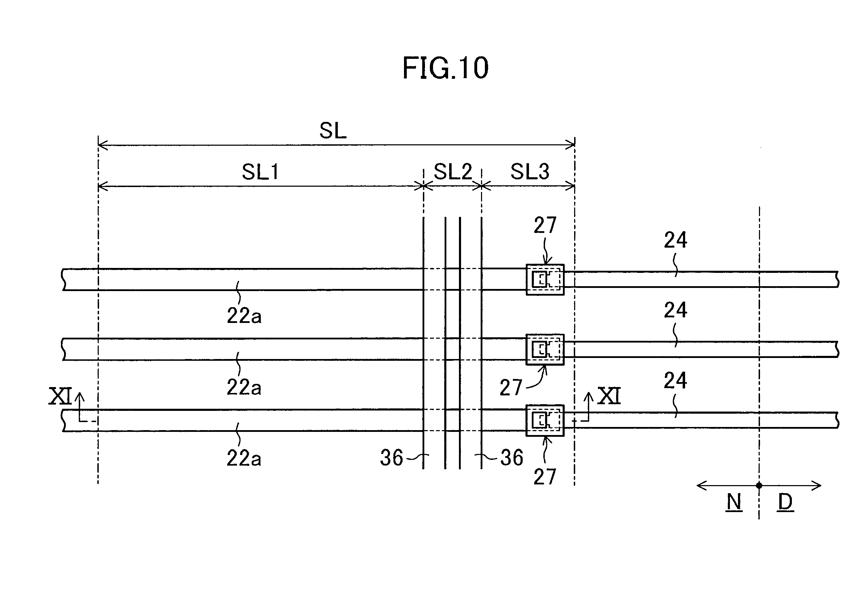

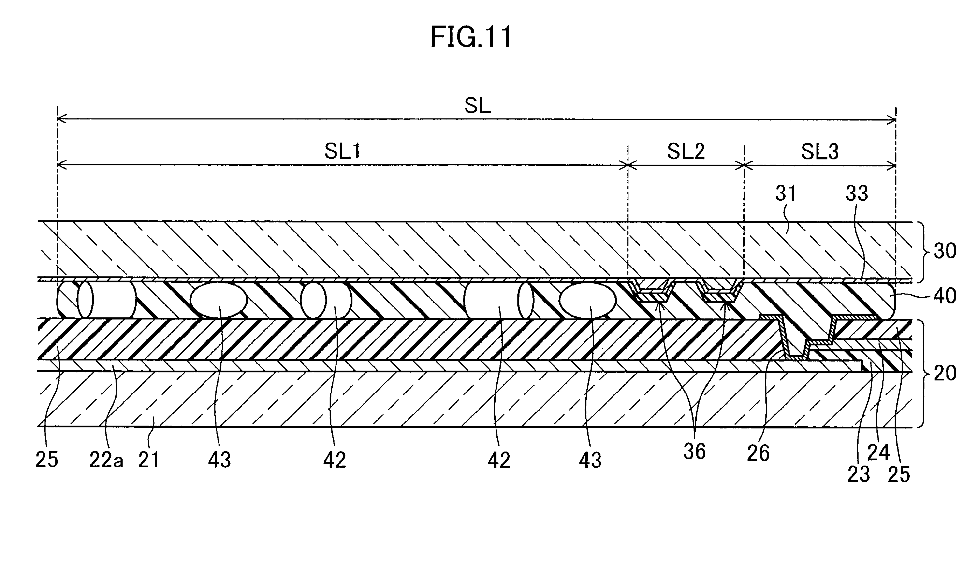

The sealing member 40 is arranged in the shape of a continuously extending frame in the non-display region N in the seal region SL along the perimeter of the counter substrate 30, and bonds the array substrate 20 and the counter substrate 30 together. FIG. 10 is a plan view showing a region in the vicinity of the non-display region N of the liquid crystal display device 10. FIG. 11 is a cross-sectional view taken along line XI-XI of FIG. 10.

The sealing member 40 is formed of a sealing member material 41 containing a flowable adhesive (e.g., a heat curable resin, a UV curable resin, etc.) as a major component, that is cured by heating or irradiation with UV. The sealing member 40 contains, as in-sealing-member materials, at least either of the pulverized glass fiber materials 42 and the conductive beads 43.

The pulverized glass fiber material 42 is produced, for example, by pulverizing a glass fiber having a diameter of about 5 µm into pieces having a length of about 20 µm. The fiber diameter of the pulverized glass fiber material 42 is set to correspond to the substrate-to-substrate distance between the array substrate 20 and the counter substrate 30. As a result, the pulverized glass fiber material 42 functions as a spacer between the two substrates.

The distribution density of the pulverized glass fiber materials 42 in the sealing member 40 varies from region to region in the seal region SL. Specifically, the pulverized glass fiber materials 42 are distributed so that the distribution density of the pulverized glass fiber materials 42 in the sealing member 40 in the region SL2 corresponding to the protruding rib 36 is lower than that in the region SL1 which is located further from the center of the substrate than the protruding rib 36. For example, the distribution density of the pulverized glass fiber materials 42 in the sealing member 40 in the region SL1 which is located further from the center of the substrate than the protruding rib 36 is about 1-2 pieces per unit area which is a square with each side 400 µm long, and the distribution density of the pulverized glass fiber materials 42 in the sealing member 40 in the region SL2 corresponding to the protruding rib 36 is about 1-2 pieces per unit area which is a square with each side 800 µm long. In conventional liquid crystal display devices, as shown in FIG. 24, when the pulverized glass fiber material 142 is present in a region corresponding to the protruding rib 136, i.e., the pulverized glass fiber material 142 is interposed between the protruding rib 136 and the array substrate 120 while being stuck on top of the protruding rib 136, the distance between the tip of the protruding rib 136 and the surface of the array substrate 120 corresponds to the fiber diameter of the pulverized glass fiber material 142, and therefore, it is difficult to set the distance between the array substrate 120 and the counter substrate 130 to an intended value, i.e., it is difficult to control the cell thickness. However, in the liquid crystal display device 10 of the first embodiment, the pulverized glass fiber material 42 is contained so that the distribution density of the pulverized glass fiber materials 42 in the sealing member 40 in the region SL2 corresponding to the protruding rib 36 is lower than that in the region SL1 which is located further from the center of the substrate than the protruding rib 36. As a result, the number of the pulverized glass fiber materials 42 stuck on top of the protruding ribs 36 can be reduced, and therefore, it is possible to reduce or avoid the situation that the cell thickness cannot be controlled due to the pulverized glass fiber material 42 stuck on top of the protruding rib 36.

The distribution density of the pulverized glass fiber materials 42 in the sealing member 40 in the region SL2 corresponding to the protruding rib 36 is preferably lower than or equal to 1/4 of that in the region SL1 which is located further from the center of the substrate than the protruding rib 36. Here, the reason why the distribution density of the pulverized glass fiber materials 42 in the sealing member 40 in the region SL2 corresponding to the protruding rib 36 is preferably lower than or equal to 1/4 of that in the region SL1 which is located further from the center of the substrate than the protruding rib 36, is as follows. In a prototype of the first embodiment, the distribution density of the pulverized glass fiber materials 42 in the sealing member 40 in each region SL1, SL2 was measured using an optical microscope. The distribution density of the pulverized glass fiber materials 42 in the sealing member 40 in the region SL2 corresponding to the protruding rib 36 was about 1/4 of that in the region SL1 which is located further from the center of the substrate than the protruding rib 36. In addition, the cell thickness was able to be efficiently controlled in this prototype, compared to comparative samples which had a uniform distribution density over the entire region.

Note that, in the region SL2 corresponding to the protruding rib 36, the pulverized glass fiber material 42 may not be contained in the sealing member 40.

The conductive bead 43 is, for example, a polymer bead with gold deposited on an outer surface thereof. The conductive bead 43 has an outer diameter of, for example, 6-7 µm. The conductive bead 43 functions as a transfer member for electrically connecting the common electrode 33 of the counter substrate 30 and interconnects (not shown) provided in the picture-frame region of the array substrate 20 together. In this case, in order to reliably establish conduction between the common electrode 33 and a drive circuit, the outer diameter of the conductive bead 43 is preferably larger than or equal to the fiber diameter of the pulverized glass fiber material 42, i.e., the distance between the two substrates, more preferably larger than the fiber diameter of the pulverized glass fiber material 42. Note that when the diameter of the conductive bead 43 is larger than the distance between the two substrates, the conductive bead 43 establishes conduction between the common electrode 33 and the interconnect while being sandwiched by the substrates and thereby being deformed, for example, into the shape of an oval sphere.

The distribution density of the conductive beads 43 in the sealing member 40 varies from region to region in the seal region SL. Specifically, the conductive beads 43 are distributed so that the distribution densities of the conductive beads 43 in the sealing member 40, in the region SL2 corresponding to the protruding rib 36 and the region SL3 closer to the display region D than the protruding rib 36, are lower than that in the region SL1 which is located further from the center of the substrate than the protruding rib 36. When the conductive bead 43 is present in a region located closer to the display region D than the protruding rib 36, it is likely that the common electrode 33 provided in the counter substrate 30 and the pixel electrode or the interconnect switching electrode 26 provided in the array substrate 20 are electrically connected together by the conductive bead 43, so that an unintended leakage current occurs. However, the conductive bead 43 is contained so that the distribution densities of the conductive beads 43 in the sealing member 40, in the region SL2 corresponding to the protruding rib 36 and in the region SL3 closer to the display region D than the protruding rib 36, are lower than that in the region SL1 which is located further from the center of the substrate than the protruding rib 36, it is possible to reduce or prevent occurrence of the unintended leakage current between the two substrates. Also, since the diameter of the conductive bead is larger than the diameter of the glass fiber and the cell thickness is defined by the glass fiber, the conductive bead can be reduced or prevented from entering the region SL3.

Note that the conductive bead 43 may not be contained in the sealing member 40 in the region SL2 corresponding to the protruding rib 36 or the region SL3 closer to the display region D than the protruding rib 36.

### (Liquid Crystal Layer)

The liquid crystal layer 50 is formed, for example, of a nematic liquid crystal material having electro-optic properties.

In the liquid crystal display device 10 thus configured, one pixel is provided for each pixel electrode. In each pixel, when a gate signal is received from the gate line 22 to turn on the TFT, a source signal is received from the source line 24 to write predetermined charge via the source and drain electrodes to the pixel electrode, so that a potential difference occurs between the pixel electrode and the common electrode 33 of the counter substrate 30, whereby a predetermined voltage is applied to a liquid crystal capacitor formed of the liquid crystal layer 50. In the liquid crystal display device 10, an image is displayed by adjusting the transmittance of external incident light by utilizing the phenomenon that the alignment of liquid crystal molecules varies depending on the magnitude of the applied voltage.

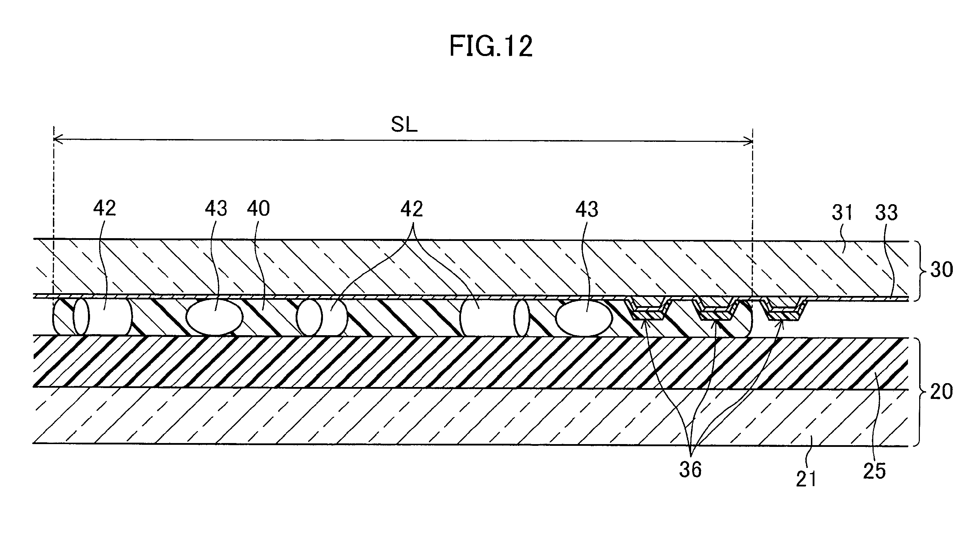

Although the foregoing example illustrates that all of the protruding ribs 36 are provided in the midway portion in the width direction of the seal region SL, as shown in FIG. 12 at least the outermost protruding rib 36 may be provided in the midway portion in the width direction of the seal region SL, and a protruding rib 36 may be further provided in a region located closer to the display region D than the seal region SL.

Although the foregoing example illustrates that a plurality of protruding ribs 36 are provided side by side in the seal region SL, only one protruding rib 36 may be provided. Note that two or more protruding ribs 36 are preferably provided in order to reduce or prevent the alignment film 34 from flowing out over the protruding rib 36 during formation of the alignment film 34 or reduce or prevent the pulverized glass fiber material 42 or the conductive bead 43 from being stuck on top of the protruding rib 36 and flowing into the region SL3 located further inside than the protruding rib 36. Three or less protruding ribs 36 are preferably provided in order to obtain a narrower picture-frame.

Although the foregoing example illustrates that the protruding rib 36 is formed around the display region D in the shape of a frame continuously extending along the frame-like sealing member 40, the protruding rib 36 may include separate portions or may meander, for example. The protruding rib 36 may have other layouts, depending on each shape. Note that the protruding rib 36 is preferably formed in the shape of a frame continuously extending along the sealing member 40 in order to reduce or prevent the alignment film 34 from flowing out over the protruding rib 36 during formation of the alignment film 34 or reduce or prevent the pulverized glass fiber material 42 or the conductive bead 43 from being stuck on top of the protruding rib 36 and flowing into the region SL3 located further inside than the protruding rib 36.

### <Method for Manufacturing Liquid Crystal Display Device>

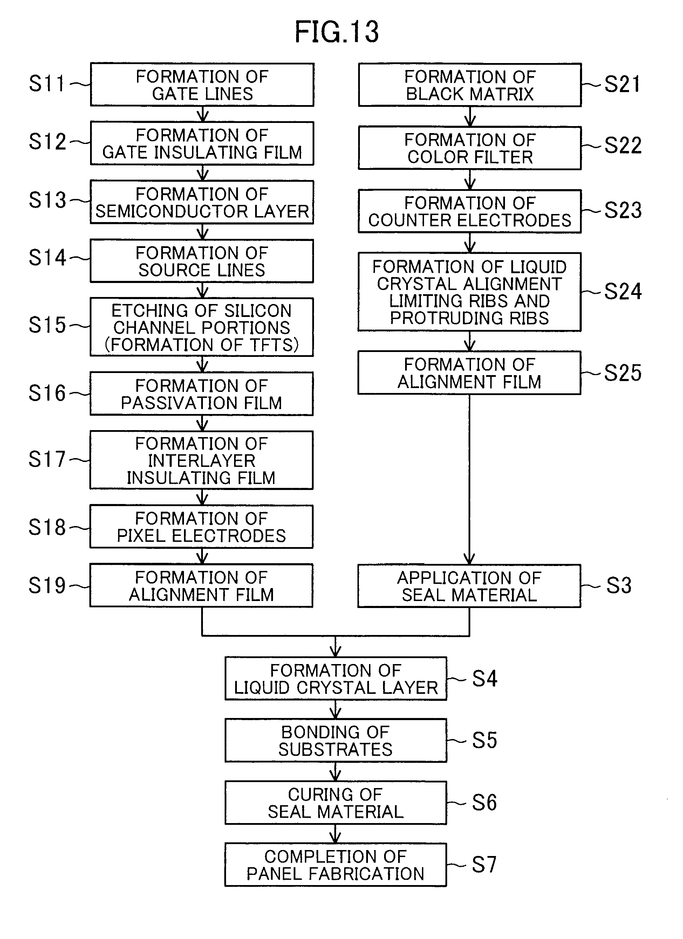

Next, a method for manufacturing the liquid crystal display device 10 of the first embodiment will be described with reference to a flowchart shown in FIG. 13. The manufacturing method of the first embodiment includes an array substrate fabrication process corresponding to steps S11-S19 of FIG. 13, a counter substrate fabrication process corresponding to steps S21-S25 of FIG. 13, and a liquid crystal display panel fabrication process corresponding to steps S3-S7 of FIG. 13.

### (Array Substrate Fabrication Process)

Initially, in steps S11-S14, the gate lines 22 (including the lead lines 22a when the interconnection switching portions 27 are formed) and gate electrodes which are first interconnects, the gate insulating film 23, the semiconductor layer, and the source lines 24, source electrodes, and drain electrodes which are second interconnects, are successively formed on the substrate body 21 by known techniques. In step S 15, channel portions are formed in the semiconductor layer by patterning to form the TFTs.

Next, in steps S16 and S 17, the passivation film and the interlayer insulating film 25 are successively formed by known techniques. In step S 18, the pixel electrodes are formed, corresponding to the respective contact holes in the interlayer insulating film 25.

Finally, in step S19, the alignment film is formed by a known technique to complete fabrication of the array substrate 20.

### (Counter Substrate Fabrication Process)

Initially, in step S21, a black matrix is formed on the substrate body 31 by a known technique.

Next, in step S22, the color filter layers 32 and 36a are formed by a known technique. In this case, in the display region D, the color filter layer 32 corresponding to each pixel is formed, and in the non-display region N, patterning is performed to provide a layout along the outer perimeter portion of the counter substrate 30. The protruding color filter 36a formed in the outer perimeter portion, surrounding the display region D, is a portion of the protruding rib 36.

Next, in step S23, a transparent conductive film is formed to cover the entire substrate by a known technique to form the common electrode 33. In this case, the common electrode 33 in the non-display region N serves as the transparent conductive film 36b which covers the color filter 36a which is a portion of the protruding rib 36.

Next, in step S24, an organic resin film of a transparent material (e.g., photosensitive acrylic resin, etc.) having a thickness of, for example, about 1.5 µm is formed by spin coating. Thereafter, in the display region D, patterning is performed to form the liquid crystal alignment limiting rib 35 in a predetermined region, and at the same time, in the non-display region N, patterning is performed to form the transparent resin 36c which covers the transparent conductive film 36b in a region in which the protruding rib 36 is formed. Thus, the liquid crystal alignment limiting rib 35 and the protruding rib 36 are simultaneously formed.

Although the foregoing example illustrates that the liquid crystal alignment limiting rib 35 and the protruding rib 36 are simultaneously formed, the liquid crystal alignment limiting rib 35 and the protruding rib 36 may be formed in separate steps. For example, patterning is performed on an organic resin to cover the liquid crystal alignment limiting rib 35, and thereafter, patterning is performed on a different type of organic resin to cover the color filter 36a of the protruding rib 36. The protruding rib 36 may be formed earlier than the liquid crystal alignment limiting rib 35.

Finally, in step S25, polyimide resin, etc., is applied by inkjet printing, and thereafter, a rubbing alignment treatment is performed, to form the alignment film 34. In this case, in step S24, the protruding rib 36 is formed in the non-display region N in the outer perimeter portion of the display region D, corresponding to the seal region SL. Therefore, even when the alignment film 34 is formed by inkjet application, the alignment film 34 can be reduced or prevented from flowing out over a portion of the non-display region N in which the protruding rib 36 is provided.

Although the foregoing example illustrates that a rubbing treatment is performed on the substrate surface to form the alignment film 34 which is of horizontal alignment type, an alignment film which is of vertical alignment type may be formed without performing a rubbing treatment on the substrate surface.

Thus, fabrication of the counter substrate 30 is completed.

Although the foregoing example illustrates that, in the counter substrate fabrication process, the color filter 36a is also formed in the non-display region N by patterning, the transparent conductive film 36b and the transparent resin 36c are formed and stacked together on the color filter 36a to form the protruding rib 36, the present invention is not particularly limited to this. For example, a material different from the color filter layer 32 may be formed in the non-display region N by patterning in a step separated from formation of the color filter layer 32 in the display region D, and thereafter, the transparent conductive film 36b and the transparent resin 36c may be formed and stacked together on the color filter layer 32, to form the protruding rib 36.

### (Liquid Crystal Display Panel Fabrication Process)

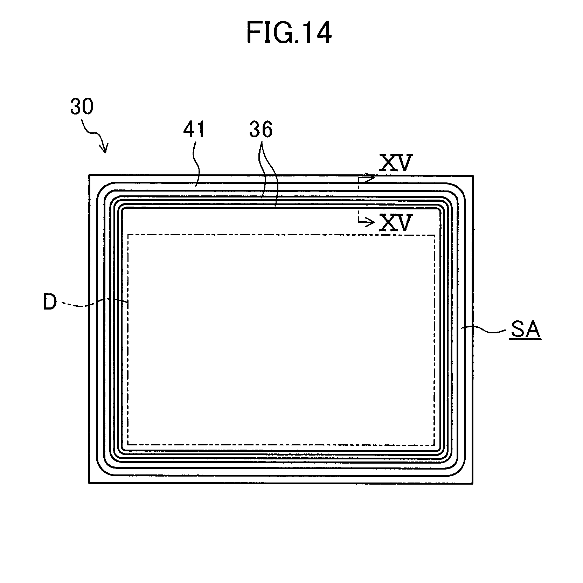

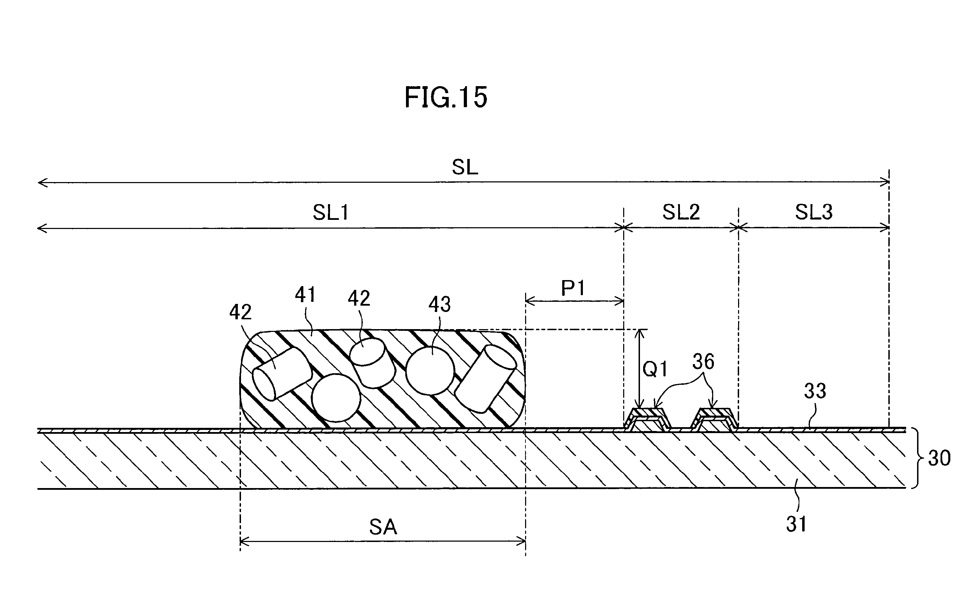

Initially, in step S3, as shown in FIGS. 14 and 15, the sealing member material 41 is applied around the display region D, for example, using a dispenser, screen printing, etc., into a frame shape surrounding the outer perimeter portion of the counter substrate 30.

In this case, the sealing member material 41 is applied in a region (hereinafter referred to as a sealing member material applied region SA) which is located further from the center of the substrate than the protruding rib 36 (the sealing member material applied region SA is included in the region SL1), and the sealing member material 41 is not applied to the region SL2 in which the protruding rib 36 is formed or the region SL3 which is located further inside than the protruding rib 36. Note that the distance (a length P1 in FIG. 15) between the sealing member material applied region SA and the region in which the protruding rib 36 is provided is preferably 100-300 µm. The difference (a length Q1 in FIG. 15) between the thickness of the sealing member material 41 applied in the sealing member material applied region SA and the height of the protruding rib 36 is preferably 5-10 µm.

Next, in step S4, a liquid crystal material is dropped onto the substrate in the region surrounded by the sealing member material 41 (the sealing member 40), for example, using a dispenser, etc., to form the liquid crystal layer.

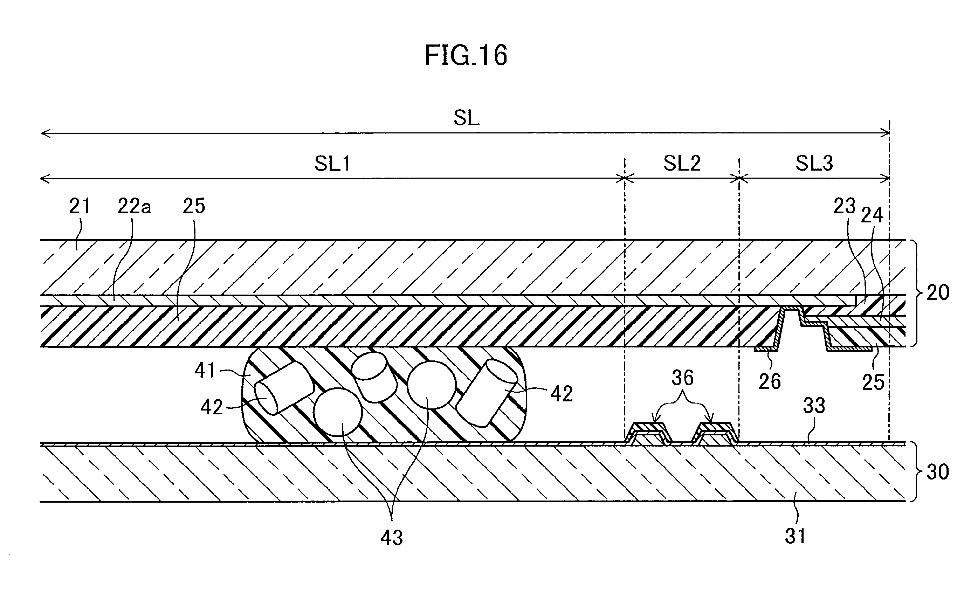

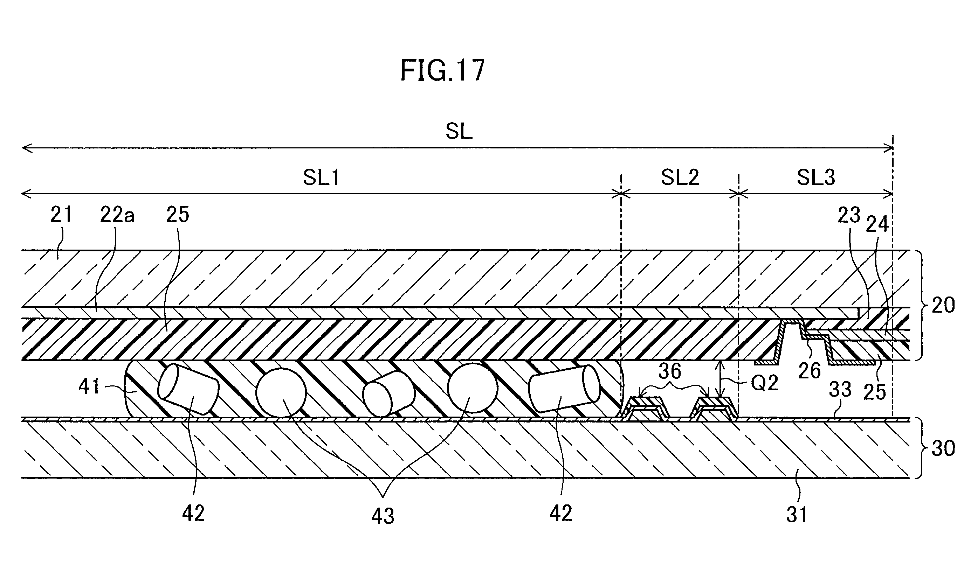

Next, in step S5, as shown in FIG. 16, the array substrate 20 and the counter substrate 30 are positioned so that the respective display regions D correspond to each other. The two substrates 20 and 30 are put on top of each other with the sealing member material 41 being interposed therebetween and are then pressed against each other, whereby the adhesive flows and spreads. As a result, as shown in FIG. 17, an end portion of the adhesive region has reached the protruding rib 36.

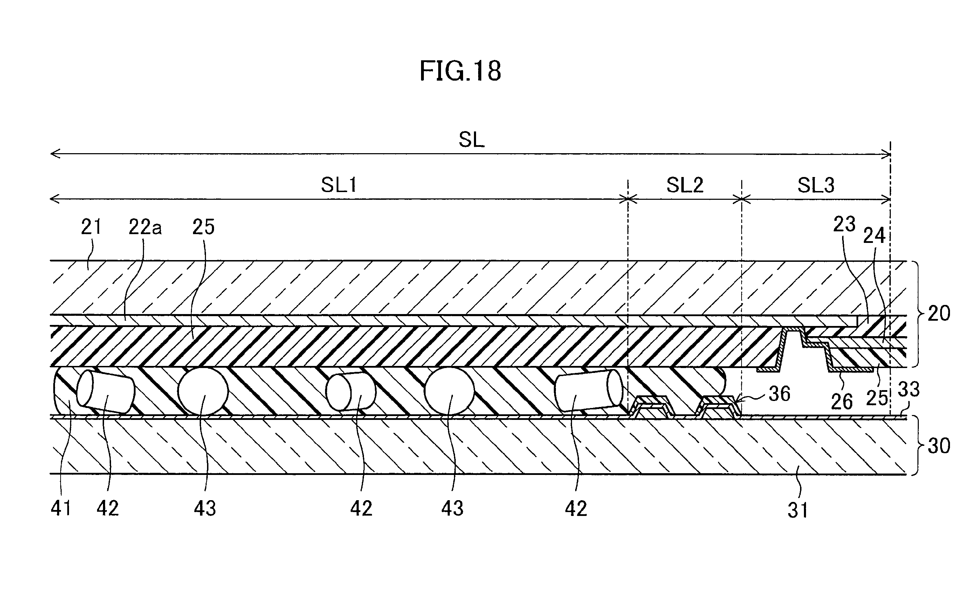

In the state of FIG. 17 in which the end portion of the adhesive region has reached the protruding rib 36, the distance Q2 between the tip of the protruding rib 36 and the surface of the array substrate 20 is set to be smaller than the fiber diameter of the pulverized glass fiber material 42 or the diameter of the conductive bead 43. In this case, even if the adhesive is further pressed and spread than in the state of FIG. 17 to flow into the region SL2 in which the protruding rib 36 is provided (FIG. 18), the entering of the pulverized glass fiber material 42 and the conductive bead 43 to the region in which the protruding rib 36 is provided, is limited because the distance Q2 between the tip of the protruding rib 36 and the surface of the array substrate 20 is smaller than the diameters of the pulverized glass fiber material 42 and the conductive bead 43, whereby the pulverized glass fiber material 42 and the conductive bead 43 are reduced or prevented from flowing into the display region D. Therefore, the distribution densities of the region SL2 corresponding to the protruding rib 36 and the region SL3 located further inside than the protruding rib 36 are lower than the distribution density of the region SL1 located further from the center of the substrate than the protruding rib 36. Note that, when the sealing member material 41 is applied onto the substrate, then if, as shown in FIG. 15, the length P1 and the length Q1 are set to 100-300 µm and 5-10 µm, respectively, the distance Q2 between the tip of the protruding rib 36 and the surface of the array substrate 20 can be set to be smaller than the fiber diameter of the pulverized glass fiber material 42 and the diameter of the conductive bead 43.

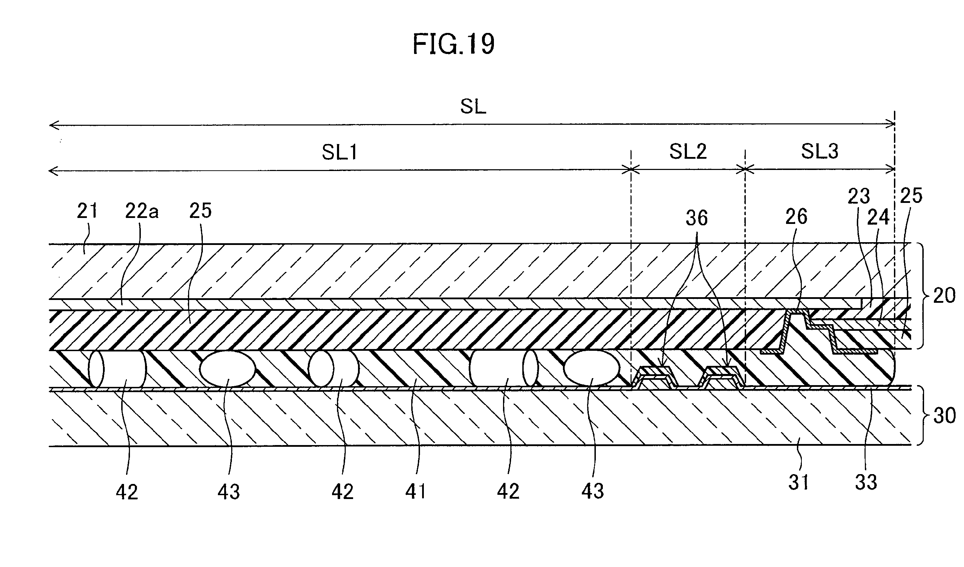

Next, as shown in FIG. 19, by further pressing the two substrates against each other, the pulverized glass fiber material 42 is sandwiched as a spacer between the two substrates, so that the two substrates 20 and 30 can no longer approach each other. At this time, a region in which the sealing member material 41 has spread is the seal region SL of the liquid crystal display device 10.

Finally, in step S6, the sealing member material 41 is cured by UV irradiation and/or heating.

Thus, the liquid crystal display panel is fabricated (step S7), and the liquid crystal display device 10 of the first embodiment can be manufactured.

In the liquid crystal display device 10 of the first embodiment, when the sealing member 40 is formed, the sealing member material 41 is applied to the sealing member material applied region SA (the region located further from the center of the substrate than the protruding rib 36), and the array substrate 20 and the counter substrate 30 are bonded together. Therefore, the sealing member 40 is provided so that the distribution density of the pulverized glass fiber materials 42 in the sealing member 40 in the region SL2 corresponding to the protruding rib 36 is lower than that in the region located further from the center of the substrate than the protruding rib 36. Therefore, it is possible to overcome the problem that the pulverized glass fiber material 42 present in the region SL2 corresponding to the protruding rib 36 makes it to difficult to control the cell thickness of the liquid crystal display device 10. By efficiently controlling the cell thickness, excellent optical characteristics can be obtained, and therefore, the liquid crystal display device 10 can have desired display quality.

In the liquid crystal display device 10 of the first embodiment, when the sealing member 40 is formed, the sealing member material 41 is applied to the sealing member material applied region SA (the region located further from the center of the substrate than the protruding rib 36), and the array substrate 20 and the counter substrate 30 are bonded together. Therefore, the sealing member 40 is provided so that the distribution density of the conductive beads 43 in the sealing member 40 in the region SL2 corresponding to the protruding rib 36 and the region SL3 closer to the display region D than the protruding rib 36 is lower than the distribution density of the conductive beads 43 in the sealing member 40 in the region SL1 located further from the center of the substrate than the protruding rib 36. Therefore, it is possible to reduce or prevent occurrence of an unintended leakage current which is caused by the common electrode 33 of the counter substrate 30 and the pixel electrode of the array substrate 20 being electrically connected by the conductive bead 43 present in the region SL3 located further inside than the protruding rib 36.

Although the foregoing example in the first embodiment illustrates that the protruding rib 36 is formed on the counter substrate 30, the protruding rib 36 may be provided in the non-display region N of the array substrate 20. In this case, the sealing member material 41 is applied to the array substrate 20 in the region SL1 located further from the center of the substrate than the protruding rib 36 (here, the region SL1 is the sealing member material applied region SA). The protruding rib 36 may be provided on both the array substrate 20 and the counter substrate 30.

### «Second Embodiment»

Next, a liquid crystal display device 10 according to the second embodiment will be described.

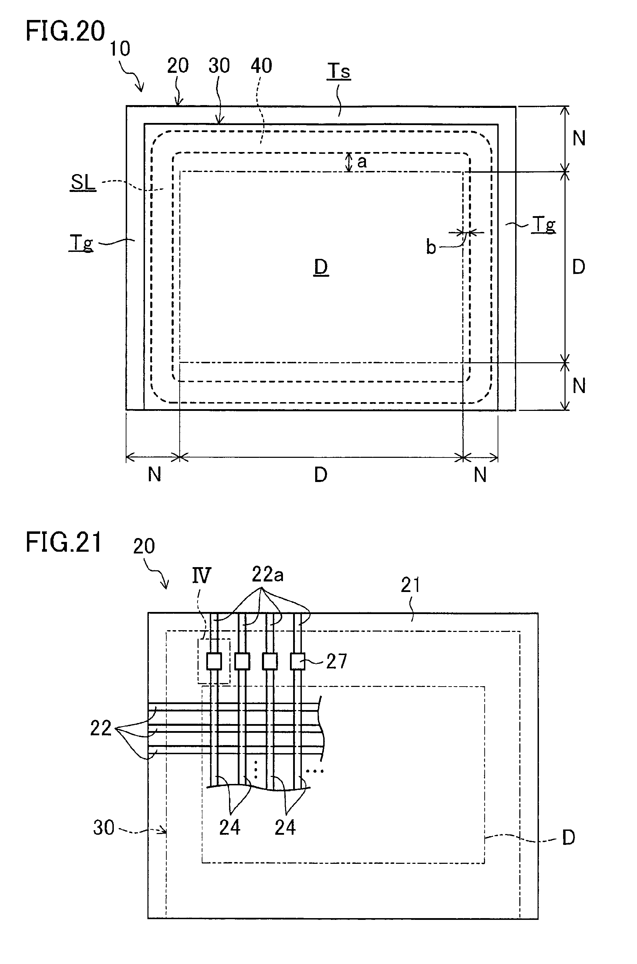

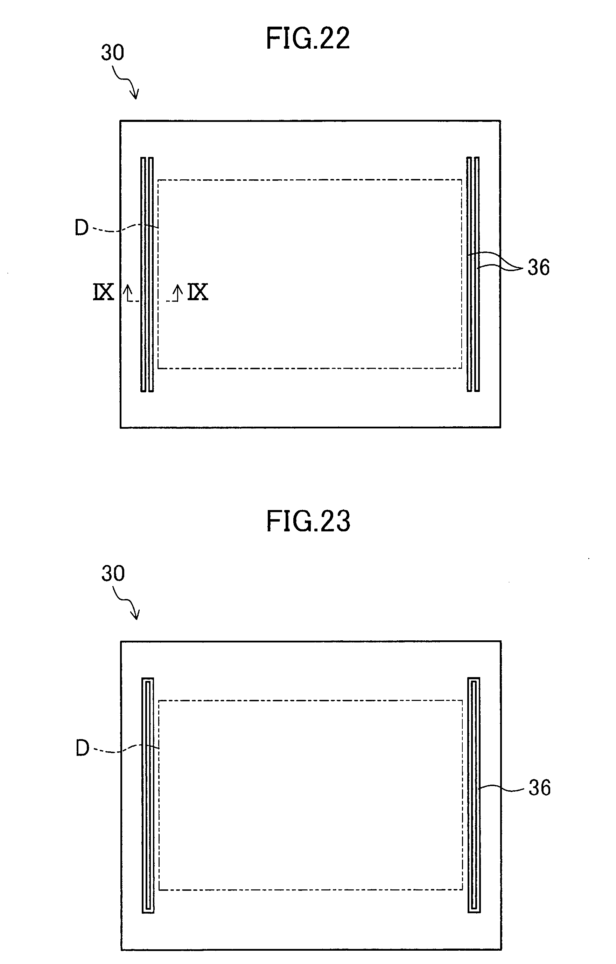

FIG. 20 is a diagram schematically showing the entire liquid crystal display device 10 of the second embodiment. FIGS. 21 and 22 are plan views of an array substrate 20 and a counter substrate 30, respectively. Note that parts which are the same as or corresponding to those of the first embodiment are indicated by the same reference characters as those of the first embodiment.

The liquid crystal display device 10 includes the array substrate 20 and the counter substrate 30, which face each other and are bonded together by a sealing member 40 provided in an outer perimeter portion (seal region SL) thereof, and a liquid crystal layer 50 which is provided as a display layer in a space enclosed by the sealing member 40. A region in which the liquid crystal layer 50 is provided is a display region D, and a frame-shaped non-display region N is provided around the display region D. The non-display region N has a source terminal region Ts in a portion of one longer side of the liquid crystal display device 10 and gate terminal regions Tg in portions of two shorter sides of the liquid crystal display device 10. The seal region SL is arranged so that a distance between (a length "a" in FIG. 27) between the display region D and the seal region SL at the longer side of the liquid crystal display device 10 is longer than a distance (a length "b" in FIG. 27) between the display region D and the seal region SL at the shorter side of the liquid crystal display device 10.

### (Array Substrate)

As shown in FIG. 21, in the array substrate 20, a plurality of gate lines (first interconnects) 22 having a multilayer structure including, for example, a Ti film (thickness: about 50 nm), an Al film (thickness: about 300 nm), and a Ti film (thickness: about 50 nm) are provided on a substrate body 21, extending in parallel to each other, and a gate insulating film 23 (see FIG. 5), for example, of SiN having a thickness of 400 nm is provided to cover the gate lines 22. A plurality of source lines (second interconnects) 24 having a multilayer structure including, for example, an Al film (thickness: about 300 nm) and a Ti film (thickness: about 50 nm) are provided on the gate insulating film 23, extending in parallel to each other in a direction perpendicular to the gate lines 22.

In the display region D, a semiconductor layer is provided at intersection portions of the gate lines 22 and the source lines 24 to form TFTs (not shown). A passivation film (not shown), for example, of SiN having a thickness of 250 nm is provided to cover the TFTs. An interlayer insulating film 25, for example, of photosensitive acrylic resin having a thickness of 2.5 µm is provided to cover the passivation film. A contact hole (not shown) extending from a surface of the interlayer insulating film 25 to a TFT is provided for each pixel. A pixel electrode (not shown), for example, of ITO is provided for each contact hole. An alignment film (not shown) is provided on the pixel electrodes, covering the display region D.

The source line 24 is electrically connected to a lead line 22a provided in the same layer in which the gate line 22 is provided, in the non-display region N. A source line end portion 24t is positioned above a lead line end portion 22at, overlapping the lead line end portion 22at as viewed from above, a contact hole 27c extending to both the source line 24 and the lead line 22a is formed, and an interconnect switching electrode 26 is provided to cover a surface of the contact hole 27c, and these components constitute an interconnection switching portion 27. Note that the interconnect switching electrode 26 is provided in the same layer in which the pixel electrode is provided, in the display region D. Note that the interconnection switching portion 27 has the same enlarged plan view (a portion indicated by a region IV in FIG. 21) and cross-sectional view as those of the first embodiment of FIGS. 4 and 5.

### (Counter Substrate)

FIG. 22 is a plan view of the counter substrate 30. A cross-sectional view taken along line IX-IX of FIG. 22 is the same as that of FIG. 9 described in the first embodiment. In the counter substrate 30, a color filter layer 32 having a thickness of, for example, 2 µm is provided on a substrate body 31 in the display region D. The color filter layer 32 includes color layers 32a having one of red, green, and blue colors corresponding to the respective pixel electrodes of the array substrate 20, and a black matrix 32b provided between each color layer 32a. A common electrode 33, for example, of ITO having a thickness of 100 nm is provided on the color filter layer 32 over the entire substrate surface. An alignment film 34 of transparent organic resin (e.g., polyimide, etc.) is provided to cover the common electrode 33.

When the liquid crystal display device 10 is of vertical alignment type, the counter substrate 30 includes liquid crystal alignment limiting ribs 35 for limiting the alignment direction of liquid crystal molecules, in the display region D. The liquid crystal alignment limiting rib 35 protrudes from a surface of the counter substrate 30 toward the array substrate 20. The liquid crystal alignment limiting rib 35 has a triangular cross-sectional shape, for example. In the driven state, the liquid crystal alignment limiting rib 35 substantially limits the alignment direction of each liquid crystal molecule to the protruding direction of the rib to reduce or avoid a situation that falling liquid crystal molecules interact with each other to cause the twist angle of the liquid crystal molecule to vary in a plane of the liquid crystal layer 50. As a result, high-quality display having a high contrast ratio can be provided. The liquid crystal alignment limiting rib 35 is formed, for example, of a transparent organic resin material or a transparent inorganic material, etc. The liquid crystal alignment limiting rib 35 may have insulating properties or dielectric properties.

In the counter substrate 30, protruding ribs 36 which extend along a direction of the seal region SL and protrude toward the array substrate 20 are provided in a midway portion in a width direction of the seal region SL in which the sealing member 40 is formed. The protruding rib 36 extends along two opposite sides along the gate terminal region Tg of the substrate outer perimeter portion. For example, a plurality of the protruding ribs 36 are arranged side by side in the width direction (two lines in FIG. 22) in each region along the gate terminal region Tg. The protruding rib 36 is formed, for example, of a multilayer structure of a color filter 36a, a transparent conductive film 36b, and a transparent resin 36c. The color filter 36a has a thickness of, for example, 1-3 µm. The transparent conductive film 36b is formed, for example, of an ITO film having a thickness of about 100 nm, and serves as a common electrode covering the entire surface of the counter substrate 30. The transparent resin 36c is, for example, photosensitive acrylic resin having a thickness of 1.5 µm. The protruding rib 36 has a function of reducing or preventing the alignment film 34 from flowing out over the protruding rib 36 during formation of the alignment film 34, at the two opposite sides along the gate terminal region Tg. The protruding rib 36 also has a function of reducing or preventing pulverized glass fiber materials 42 or conductive beads 43 contained in the sealing member 40 from being stuck on top of the protruding rib 36 and flowing into a region SL3 located further inside than the protruding rib 36.

Each protruding rib 36 has a width of about 50 µm and a height of 3-6 µm and has a generally-trapezoidal cross-section taken along the width direction, for example. Note that the protruding rib 36 is designed so that a gap is formed between the protruding rib 36 and the array substrate 20, i.e., the height of the protruding rib 36 is smaller than the distance between the array substrate 20 and the counter substrate 30. The adjacent protruding ribs 36 arranged side by side in the width direction are spaced apart from each other by a distance of, for example, about 25 µm. The protruding rib 36 is preferably provided at a position which is located further inside (closer to the display region D) in a midway portion in the width direction of the seal region SL. For example, the protruding rib 36 is formed in a region which is located about 100 µm away from an inner end of the seal region SL in the width direction of the seal region SL.

Although the foregoing example in FIG. 22 illustrates that the two protruding ribs 36 are provided side by side, end portions of the two protruding ribs 36 may be closed as shown in FIG. 23.

Although the foregoing example illustrates that the liquid crystal alignment limiting rib 35 is provided in the counter substrate 30, the liquid crystal alignment limiting rib 35 may be removed.

### (Sealing Member)

The sealing member 40 is arranged in the shape of a continuously extending frame in the non-display region N in the seal region SL along the perimeter of the counter substrate 30, and bonds the array substrate 20 and the counter substrate 30 together.

The sealing member 40 is formed of a sealing member material 41 containing a flowable adhesive (e.g., a heat curable resin, a UV curable resin, etc.) as a major component, that is cured by heating or irradiation with UV. The sealing member 40 contains, as in-sealing-member materials, at least either of the pulverized glass fiber materials 42 and the conductive beads 43.

The pulverized glass fiber material 42 is produced, for example, by pulverizing a glass fiber having a diameter of about 5 µm into pieces having a length of about 20 µm. The fiber diameter of the pulverized glass fiber material 42 is set to correspond to the substrate-to-substrate distance between the array substrate 20 and the counter substrate 30. As a result, the pulverized glass fiber material 42 functions as a spacer between the two substrates.

The distribution density of the pulverized glass fiber materials 42 in the sealing member 40 varies from region to region in the seal region SL. Specifically, the pulverized glass fiber materials 42 are distributed so that the distribution density of the pulverized glass fiber materials 42 in the sealing member 40 in a region SL2 corresponding to the protruding rib 36 is lower than that in a region SL1 which is located further from the center of the substrate than the protruding rib 36. For example, the distribution density of the pulverized glass fiber materials 42 in the sealing member 40 in the region SL1 which is located further from the center of the substrate than the protruding rib 36 is about 1-2 pieces per unit area which is a square with each side 400 µm long, and the distribution density of the pulverized glass fiber materials 42 in the sealing member 40 in the region SL2 corresponding to the protruding rib 36 is about 1-2 pieces per unit area which is a square with each side 800 µm long. In conventional liquid crystal display devices, as shown in FIG. 24, when the pulverized glass fiber material 142 is present in a region corresponding to the protruding rib 136, i.e., the pulverized glass fiber material 142 is interposed between the protruding rib 136 and the array substrate 120 while being stuck on top of the protruding rib 136, the distance between the tip of the protruding rib 136 and the surface of the array substrate 120 corresponds to the fiber diameter of the pulverized glass fiber material 142, and therefore, it is difficult to set the distance between the array substrate 120 and the counter substrate 130 to an intended value, i.e., it is difficult to control the cell thickness. However, in the liquid crystal display device 10 of the second embodiment, the pulverized glass fiber material 42 is contained so that the distribution density of the pulverized glass fiber materials 42 in the sealing member 40 in the region SL2 corresponding to the protruding rib 36 is lower than that in the region SL 1 which is located further from the center of the substrate than the protruding rib 36. As a result, the number of the pulverized glass fiber materials 42 stuck on top of the protruding ribs 36 can be reduced, and therefore, it is possible to reduce or avoid the situation that the cell thickness cannot be controlled due to the pulverized glass fiber material 42 stuck on top of the protruding rib 36.

The distribution density of the pulverized glass fiber materials 42 in the sealing member 40 in the region SL2 corresponding to the protruding rib 36 is preferably lower than or equal to 1/4 of that in the region SL1 which is located further from the center of the substrate than the protruding rib 36. Here, the reason why the distribution density of the pulverized glass fiber materials 42 in the sealing member 40 in the region SL2 corresponding to the protruding rib 36 is preferably lower than or equal to 1/4 of that in the region SL1 which is located further from the center of the substrate than the protruding rib 36, is as follows. In a prototype of the second embodiment, the distribution density of the pulverized glass fiber materials 42 in the sealing member 40 in each region SL1, SL2 was measured using an optical microscope. The distribution density of the pulverized glass fiber materials 42 in the sealing member 40 in the region SL2 corresponding to the protruding rib 36 was about 1/4 of that in the region SL1 which is located further from the center of the substrate than the protruding rib 36. In addition, the cell thickness was able to be efficiently controlled in this prototype, compared to comparative samples which had a uniform distribution density over the entire region.

Note that, in the region SL2 corresponding to the protruding rib 36, the pulverized glass fiber material 42 may not be contained in the sealing member 40.

The conductive bead 43 is, for example, a polymer bead with gold deposited on an outer surface thereof. The conductive bead 43 has an outer diameter of, for example, 6-7 µm. The conductive bead 43 functions as a transfer member for electrically connecting the common electrode 33 of the counter substrate 30 and interconnects (not shown) provided in the picture-frame region of the array substrate 20 together. In this case, in order to reliably establish conduction between the common electrode 33 and a drive circuit, the outer diameter of the conductive bead 43 is preferably larger than or equal to the fiber diameter of the pulverized glass fiber material 42, i.e., the distance between the two substrates, more preferably larger than the fiber diameter of the pulverized glass fiber material 42. Note that when the diameter of the conductive bead 43 is larger than the distance between the two substrates, the conductive bead 43 establishes conduction between the common electrode 33 and the interconnect while being sandwiched by the substrates and thereby being deformed, for example, into the shape of an oval sphere.

The distribution density of the conductive beads 43 in the sealing member 40 varies from region to region in the seal region SL. Specifically, the conductive beads 43 are distributed so that the distribution densities of the conductive beads 43 in the sealing member 40, in the region SL2 corresponding to the protruding rib 36 and the region SL3 closer to the display region D than the protruding rib 36, are lower than that in the region SL1 which is located further from the center of the substrate than the protruding rib 36. When the conductive bead 43 is present in a region located closer to the display region D than the protruding rib 36, it is likely that the common electrode 33 provided in the counter substrate 30 and the pixel electrode or the interconnect switching electrode 26 provided in the array substrate 20 are electrically connected together by the conductive bead 43, so that an unintended leakage current occurs. However, the conductive bead 43 is contained so that the distribution densities of the conductive beads 43 in the sealing member 40, in the region SL2 corresponding to the protruding rib 36 and in the region SL3 closer to the display region D than the protruding rib 36, are lower than that in the region SL1 which is located further from the center of the substrate than the protruding rib 36, it is possible to reduce or prevent occurrence of the unintended leakage current between the two substrates. Also, since the diameter of the conductive bead is larger than the diameter of the glass fiber and the cell thickness is defined by the glass fiber, the conductive bead can be reduced or prevented from entering the region SL3.

Note that the conductive bead 43 may not be contained in the sealing member 40 in the region SL2 corresponding to the protruding rib 36 or the region SL3 closer to the display region D than the protruding rib 36.

### (Liquid Crystal Layer)

The liquid crystal layer 50 is formed, for example, of a nematic liquid crystal material having electro-optic properties.

In the liquid crystal display device 10 thus configured, one pixel is provided for each pixel electrode. In each pixel, when a gate signal is received from the gate line 22 to turn on the TFT, a source signal is received from the source line 24 to write predetermined charge via the source and drain electrodes to the pixel electrode,_so that a potential difference occurs between the pixel electrode and the common electrode 33 of the counter substrate 30, whereby a predetermined voltage is applied to a liquid crystal capacitor formed of the liquid crystal layer 50. In the liquid crystal display device 10, an image is displayed by adjusting the transmittance of external incident light by utilizing the phenomenon that the alignment of liquid crystal molecules varies depending on the magnitude of the applied voltage.

Although the foregoing example illustrates that all of the protruding ribs 36 are provided in the midway portion in the width direction of the seal region SL, as shown in FIG. 12 at least the outermost protruding rib 36 may be provided in the midway portion in the width direction of the seal region SL, and a protruding rib 36 may be further provided in a region located closer to the display region D than the seal region SL.

Although the foregoing example illustrates that a plurality of protruding ribs 36 are provided side by side in the seal region SL, only one protruding rib 36 may be provided. Note that two or more protruding ribs 36 are preferably provided in order to reduce or prevent the alignment film 34 from flowing out over the protruding rib 36 during formation of the alignment film 34 or reduce or prevent the pulverized glass fiber material 42 or the conductive bead 43 from being stuck on top of the protruding rib 36 and flowing into the region SL3 located further inside than the protruding rib 36. Three or less protruding ribs 36 are preferably provided in order to obtain a narrower picture-frame.

Although the foregoing example illustrates that the protruding rib 36 is formed around the display region D in the shape of a frame continuously extending along the frame-like sealing member 40, the protruding rib 36 may include separate portions or may meander, for example. The protruding rib 36 may have other layouts, depending on each shape. Note that the protruding rib 36 is preferably formed in the shape of a frame continuously extending along the sealing member 40 in order to reduce or prevent the alignment film 34 from flowing out over the protruding rib 36 during formation of the alignment film 34 or reduce or prevent the pulverized glass fiber material 42 or the conductive bead 43 from being stuck on top of the protruding rib 36 and flowing into the region SL3 located further inside than the protruding rib 36.

The liquid crystal display device 10 of the second embodiment can be manufactured in accordance with the flowchart of FIG. 13 as with the first embodiment, except that the sealing member material 41 is provided along the two opposite sides along the gate terminal region Tg.

In the liquid crystal display device 10 of the second embodiment, the sealing member 40, which is formed by applying the sealing member material 41 to the region (the sealing member material applied region SA) which is located further from the center of the substrate than the protruding rib 36, is used to bond the array substrate 20 and the counter substrate 30 together. As a result, the sealing member 40 is provided so that the distribution density of the pulverized glass fiber materials 42 in the sealing member 40 in the region SL2 corresponding to the protruding rib 36 is lower than that in the region which is located further from the center of the substrate than the protruding rib 36. Therefore, it is possible to overcome the problem that the pulverized glass fiber material 42 present in the region SL2 corresponding to the protruding rib 36 makes it to difficult to control the cell thickness of the liquid crystal display device 10. By efficiently controlling the cell thickness, excellent optical characteristics can be obtained, and therefore, the liquid crystal display device 10 can have desired display quality.

In the liquid crystal display device 10 of the second embodiment, the sealing member 40, which is formed by applying the sealing member material 41 to the region (the sealing member material applied region SA) which is located further from the center of the substrate than the protruding rib 36, is used to bond the array substrate 20 and the counter substrate 30 together. As a result, the sealing member 40 is provided so that the distribution densities of the conductive beads 43 in the sealing member 40 in the region SL2 corresponding to the protruding rib 36 and the region SL3 located closer to the display region D than the protruding rib 36, are lower than that in the region SL1 which is located further from the center of the substrate than the protruding rib 36. Therefore, it is possible to reduce or prevent occurrence of an unintended leakage current which is caused by the common electrode 33 of the counter substrate 30 and the pixel electrode of the array substrate 20 being electrically connected by the conductive bead 43 present in the region SL3 located further inside than the protruding rib 36.

Although the foregoing example in the second embodiment illustrates that the protruding rib 36 is formed on the counter substrate 30, the protruding rib 36 may be provided in the non-display region N of the array substrate 20. In this case, the sealing member material 41 is applied to the array substrate 20 in the region SL1 (the sealing member material applied region SA) which is located further from the center of the substrate than the protruding rib 36. The protruding rib 36 may be provided on both the array substrate 20 and the counter substrate 30.

Although the foregoing examples in the first and second embodiments illustrates the liquid crystal display device 10 including a liquid crystal display panel as an example display device, the present invention is also applicable to display devices, such as a plasma display (PD), a plasma address liquid crystal display (PALC), an organic electroluminescence (organic EL) display, an inorganic electroluminescence (inorganic EL) display, a field emission display (FED), a surface-conduction electron-emitter display (SED), etc.

### INDUSTRIAL APPLICABILITY

The present invention is useful for display devices in which two substrates facing each other are bonded by a sealing member, and methods for manufacturing the display devices.

### DESCRIPTION OF REFERENCE CHARACTERS

- D: DISPLAY REGION
- SA: SEALING MEMBER MATERIAL APPLIED REGION
- SL: SEAL REGION
- SL1: REGION LOCATED FURTHER FROM CENTER OF SUBSTRATE THAN PROTRUDING RIB
- SL2: REGION CORRESPONDING TO PROTRUDING RIB
- SL3: REGION LOCATED CLOSER TO DISPLAY REGION THAN REGION CORRESPONDING TO PROTRUDING RIB
- 10: DISPLAY DEVICE (LIQUID CRYSTAL DISPLAY DEVICE)
- 20: SECOND SUBSTRATE (ARRAY SUBSTRATE)
- 26: PROTRUDING RIB
- 30: FIRST SUBSTRATE (COUNTER SUBSTRATE)
- 32, 36a: COLOR FILTER LAYER
- 33, 36b: TRANSPARENT CONDUCTIVE FILM (COMMON ELECTRODE)
- 35: LIQUID CRYSTAL ALIGNMENT LIMITING RIB (TRANSPARENT RESIN)
- 36c: TRANSPARENT RESIN
- 40: SEALING MEMBER
- 41: SEALING MEMBER MATERIAL
- 42: PULVERIZED GLASS FIBER MATERIAL (IN-SEALING-MEMBER MATERIAL)
- 43: CONDUCTIVE BEAD (IN-SEALING-MEMBER MATERIAL)
- 50: LIQUID CRYSTAL LAYER

## Claims

1. A display device wherein
a frame-like sealing member containing in-sealing-member materials including at least either of pulverized glass fiber materials and conductive beads is provided between a first substrate and a second substrate in an outer perimeter portion thereof, and a display region is formed inside the sealing member,
a protruding rib is provided on the first substrate in a midway portion in a width direction of the sealing member, extending along the sealing member and protruding toward the second substrate with a gap being provided between the protruding rib and the second substrate, and
a distribution density of the in-sealing-member materials in the sealing member in a region corresponding to the protruding rib is lower than that in a region located further from the center of the substrate than the protruding rib, or the in-sealing-member materials are not contained in the sealing member in the region corresponding to the protruding rib.

2. The display device of claim 1, wherein
the in-sealing-member materials includes the pulverized glass fiber materials and the conductive beads,
a distribution density of the pulverized glass fiber materials in the sealing member in the region corresponding to the protruding rib is lower than that in the region located further from the center of the substrate than the protruding rib, or the pulverized glass fiber materials are not contained in the sealing member in the region corresponding to the protruding rib, and
distribution densities of the conductive beads in the sealing member in the region corresponding to the protruding rib and a region located closer to the display region than the protruding rib, are lower than that in the region located further from the center of the substrate than the protruding rib, or the conductive beads are not contained in the sealing member in the region corresponding to the protruding rib or the region located closer to the display region than the protruding rib.

3. The display device of claim 2, wherein
the distribution density of the pulverized glass fiber materials in the sealing member in the region corresponding to the protruding rib is 1/4 or less of that in the region located further from the center of the substrate than the protruding rib.

4. The display device of claim 2 or 3, wherein a diameter of the conductive beads is larger than a fiber diameter of the pulverized glass fiber materials.

5. The display device of any of claims 1-4, wherein
the first substrate has a rectangular shape, and
the protruding rib extends along two opposite sides of the first substrate included in the substrate outer perimeter portion.

6. The display device of any of claims 1-4, wherein the protruding rib is formed in the substrate outer perimeter portion in the shape of a frame surrounding the display region.

7. The display device of any of claims 1-6, wherein a liquid crystal layer is provided between the first and second substrates.

8. The display device of claim 7, wherein
the first substrate is a counter substrate including a color filter layer, and
the protruding rib has a multilayer structure including a color filter layer, a transparent conductive film, and a transparent resin.

9. The display device of claim 8, wherein the first substrate further includes, in the display region, a liquid crystal alignment limiting rib of a transparent resin protruding toward the second substrate.

10. A method for manufacturing a display device in which a frame-like sealing member containing in-sealing-member materials including at least either of pulverized glass fiber materials and conductive beads is provided between a first substrate and a second substrate in an outer perimeter portion thereof, and a display region is formed inside the sealing member, the method comprising:
providing a protruding rib along the outer perimeter portion of the first substrate;
after the providing, applying a sealing member material including a flowable adhesive and the in-sealing-member materials to the first substrate in a region located further from the center of the substrate than the protruding rib, the region being a sealing member material applied region,
after the applying, stacking the first and second substrates together while sandwiching the sealing member material and pressing the first and second substrates against each other, thereby spreading the adhesive to flow to a region located further inside than the protruding rib and limiting flow of the in-sealing-member materials into the region located further inside than the protruding rib by the protruding rib; and
after the stacking, curing the adhesive to form a frame-like sealing member in which a distribution density of the in-sealing-member materials in the sealing member in a region corresponding to the protruding rib is lower than that in the region located further from the center of the substrate than the protruding rib, or the in-sealing-member materials are not contained in the sealing member in the region corresponding to the protruding rib, thereby obtaining the display device having the display region inside the sealing member.

11. The method of claim 10, wherein
the in-sealing-member materials include the pulverized glass fiber materials and the conductive beads,
after the sealing member material is applied to the sealing member material applied region, the first and second substrates are pressed against each other while sandwiching the sealing member material, thereby spreading the adhesive to flow to the region located further inside than the protruding rib and limiting flow of the pulverized glass fiber materials and the conductive beads into the region located further inside than the protruding rib by the protruding rib, and
after the pressing, the adhesive is cured to form the sealing member in which a distribution density of the pulverized glass fiber materials in the sealing member in the region corresponding to the protruding rib is lower than that in the region located further from the center of the substrate than the protruding rib, or the pulverized glass fiber materials are not contained in the sealing member in the region corresponding to the protruding rib, and distribution densities of the conductive beads in the sealing member in the region corresponding to the protruding rib and a region located closer to the display region than the protruding rib, are lower than that in the region located further from the center of the substrate than the protruding rib, or the conductive beads are not contained in the sealing member in the region corresponding to the protruding rib or the region located closer to the display region than the protruding rib.

12. The method of claim 11, wherein a diameter of the conductive beads is larger than a fiber diameter of the pulverized glass fiber materials.

13. The method of any of claims 10-12, wherein a distance between the sealing member material applied region and a region in which the protruding rib is provided is 100-300 µm.

14. The method of any of claims 10-13, wherein
the first substrate has a rectangular shape, and
the protruding rib extends along two opposite sides of the first substrate included in the substrate outer perimeter portion.

15. The method of any of claims 10-13, wherein the protruding rib is formed in the substrate outer perimeter portion in the shape of a frame surrounding the display region.

16. The method of any of claims 10-15, wherein after the sealing member is formed, a liquid crystal material is introduced into a region surrounded by the sealing member to form a liquid crystal layer.

17. The method of any of claims 10-15, wherein after the sealing member material is applied and before the first and second substrates are bonded together, a liquid crystal material is introduced into a region surrounded by the sealing member, and after the first and second substrates are bonded together, the liquid crystal layer is formed.

18. The method of claim 16 or 17, wherein
the first substrate is a counter substrate including a color filter layer,
the protruding rib has a multilayer structure including a color filter layer, a transparent conductive film, and a transparent resin, and
the color filter layer of the protruding rib is formed simultaneously with the color filter layer provided in the counter substrate.

19. The method of claim 18, wherein
the first substrate further includes, in the display region, a liquid crystal alignment limiting rib of a transparent resin protruding toward the second substrate, and
the transparent resin of the protruding rib and the liquid crystal alignment limiting rib are simultaneously formed.
